(19) **Europäisches Patentamt**
**European Patent Office**
**Office européen des brevets**

(11) **EP 1 866 866 B1**

(12) **FASCICULE DE BREVET EUROPEEN**

(45) Date de publication et mention
de la délivrance du brevet:
**13.06.2012 Bulletin 2012/24**

(21) Numéro de dépôt: **06743657.6**

(22) Date de dépôt: **07.04.2006**

(51) Int Cl.:
***G06T 5/00*** *(2006.01)*

(86) Numéro de dépôt international:
**PCT/FR2006/000774**

(87) Numéro de publication internationale:
**WO 2006/106242 (12.10.2006 Gazette 2006/41)**

(54) **DISPOSITIF PERFECTIONNE DE TRAITEMENT D'IMAGES BRUTES OU D'IMAGES DE TENSEURS**

VERBESSERTE VORRICHTUNG ZUR VERARBEITUNG VON ROHBILDERN ODER SPANNBILDERN

IMPROVED DEVICE FOR PROCESSING RAW IMAGES OR TENSOR IMAGES

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **07.04.2005 FR 0503483**

(43) Date de publication de la demande:
**19.12.2007 Bulletin 2007/51**

(73) Titulaire: **INRIA INSTITUT NATIONAL DE RECHERCHE
EN INFORMATIQUE ET EN AUTOMATIQUE
Rocquencourt
F-78153 Le Chesnay (FR)**

(72) Inventeurs:
• **ARSIGNY, Vincent,
Résidence Marie-Lucy
F-06160 Juan Les Pins (FR)**
• **PENNEC, Xavier,
Les Cottages
F-06600 Antibes (FR)**
• **FILLARD, Pierre
F-06560 Valbonne (FR)**
• **AYACHE, Nicolas
F-06000 Nice (FR)**

(74) Mandataire: **Jacobson, Claude et al
Cabinet Lavoix
2, Place d'Estienne d'Orves
75441 Paris Cedex 09 (FR)**

(56) Documents cités:
• **FILLARD P.: "Un Cadre Riemannien pour l'Imagerie du Tenseur" 24 août 2004 (2004-08-24), INRIA - RAPPORT DE STAGE DE MASTER OPTIQUE-IMAGE-VISION , XP002358557 le document en entier**
• **PENNEC X., FILLARD P. AND AYACHE N.: "A Riemannian Framework for Tensor Computing" juillet 2004 (2004-07), INRIA TECHNICAL REPORT 5255 , XP002358558 cité dans la demande le document en entier**
• **FLETCHER P.T. AND JOSHI S.: "Principal Geodesic Analysis on Symmetric Spaces: Statistics of Diffusion Tensors" CVAMIA AND MMBIA WORKSHOPS ON COMPUTER VISION APPROACHES TO MEDICAL IMAGE ANALYSIS - LNCS 3117, 15 mai 2004 (2004-05-15), pages 87-98, XP002358553 Prague, République Tchèque cité dans la demande**
• **LE BIHAN ET AL.: "diffusion tensor imaging: concepts and applications" JOURNAL OF MAGNETIC RESONANCE IMAGING, vol. 13, 2001, pages 534-546, XP002358554**

**Description**

L'invention concerne le domaine de l'imagerie, et plus particulièrement le traitement d'images brutes ou d'images de tenseurs.

On entend ici par « image brute » une image délivrée par un imageur (ou dispositif d'acquisition d'images) sous la forme de vecteurs ou de matrices symétriques (non nécessairement définies positives), et destinée à permettre ou faciliter la production d'une image de tenseurs.

Par ailleurs, on entend ici par « tenseur » une matrice de n*n nombres qui est symétrique et définie positive. La dimension n est généralement égale à 2 dans le cas bidimensionnel (2D) ou 3 dans le cas tridimensionnel (3D), mais l'invention n'est pas limitée à ces deux valeurs. Elle concerne en effet toute valeur de n.

En outre, on entend ici par « image de tenseurs » une image représentée par un ensemble de tenseurs associés chacun à une partie élémentaire d'une grille bi ou tri-dimensionnelle. Dans le cas d'une grille bi-dimensionnelle (2D) chaque partie élémentaire est appelée « pixel », tandis que dans le cas d'une grille tri-dimensionnelle (3D) chaque partie élémentaire est appelée « voxel ».

Comme le sait l'homme de l'art, les tenseurs sont des objets mathématiques qui sont fréquemment utilisés dans le domaine de l'imagerie. C'est notamment le cas dans le domaine de l'imagerie médicale par exemple pour analyser des images de tenseurs de diffusion obtenues par résonance magnétique (technique connue sous l'acronyme anglais DT-MRI (pour « Diffusion Tensor Magnetic Resonance Imaging » - imagerie de tenseurs de diffusion obtenue par résonance magnétique, ou écrit de façon plus simple DTI pour « Diffusion Tensor Imaging »).

D'une manière générale, on entend ici par « tenseur de diffusion » la matrice de covariance d'un processus de diffusion en un point d'un milieu physique.

Les tenseurs de diffusion ne sont qu'un exemple de tenseurs parmi d'autres exemples auxquels s'applique l'invention. Parmi ces autres tenseurs, on peut notamment citer ceux qui sont utilisés pour modéliser des variations anatomiques, pour affiner ou adapter des maillages d'aires, de surfaces ou de volumes, ou encore pour effectuer des statistiques sur des résultats de recalages.

D'une manière générale, les tenseurs sont utilisés en imagerie pour effectuer des traitements de type interpolation, extrapolation, segmentation, groupement, analyse de mouvement(s) ou segmentation de texture. Les tenseurs sont aussi utilisés dans d'autres domaines comme la mécanique des milieux continus par exemple dans le cas du tenseur des contraintes.

Afin de pouvoir effectuer des calculs avec les objets que sont les tenseurs, il faut définir une distance entre tenseurs, plus connue sous le nom de « métrique », et un cadre opérationnel associé. L'espace des tenseurs constituant une partie de l'espace vectoriel des matrices carrées, il est donc possible d'utiliser une structure Euclidienne avec les matrices carrées afin d'y définir une métrique. Cette métrique est facile à utiliser et permet a priori d'effectuer des calculs relativement simples.

Cependant, les experts en imagerie se sont aperçus que ce cadre Euclidien présentait des défauts, tant sur le plan pratique que sur le plan théorique. Ils ont par conséquent proposé d'utiliser des métriques dites Riemanniennes pour l'espace des tenseurs. Grâce à ces métriques Riemanniennes, l'espace des tenseurs n'est pas borné ; les valeurs propres nulles sont rejetées à l'infini, la symétrie entre un tenseur et son inverse est respectée et une invariance affine est obtenue. Par conséquent, les calculs sont invariants par rapport aux changements affines de coordonnées. Ce cadre Riemannien est donc particulièrement attractif sur le plan théorique.

Des informations complémentaires sur le cadre Riemannien peuvent être trouvées dans le document de X. Pennec et al. « A Riemannian framework for tensor computing », Research Report 5255, INRIA, July 2004, ou dans le document de P.T. Fletcher et al « Principal geodesic analysis on symmetric spaces : Statistics of diffusion tensors », Proc. of CVAMIA and MMBIA Workshops, Prague, Czech Republic, May 15, 2004, LNCS 3117, pages 87-98, Springer, 2004, ou encore dans le document de C. Lenglet et al « Statistics on multivariate normal statistics on multivariate normal distributions : A geometric approach and its application to diffusion tensor mri », Technical report, INRIA, June 2004.

Hélas, en raison de la courbure de cet espace de Riemann, le cadre Riemannien présenté ci-avant nécessite l'utilisation d'algorithmes complexes et coûteux en temps de calcul. Il s'avère donc mal adapté à certaines situations, et notamment aux équipements d'acquisition d'images (éventuellement de tenseurs), ou imageurs, travaillant quasiment en temps réel et/ou à puissance de calcul limitée, ce qui est souvent le cas des imageurs dans le domaine hospitalier.

Aucune solution connue n'apportant une entière satisfaction, l'invention a donc pour but d'améliorer la situation en s'appuyant sur un autre cadre Riemannien, celui des métriques dites « Log-Euclidiennes », tant pour le traitement des images de tenseurs initiales que pour le traitement des images initiales brutes. Dans ce qui suit, on entend par « image initiale » soit une image de tenseurs, soit une image brute destinée à permettre ou faciliter la production d'une image de tenseurs.

L'invention propose à cet effet un premier dispositif dédié au traitement de données constituant des images de tenseurs initiales, et comprenant :

- un premier module de calcul, chargé de mettre en oeuvre une première fonction choisie, bijective, définie de l'espace R*+ dans l'espace R, et associée à une définition de métrique choisie, cette première fonction admettant une seconde fonction réciproque, et
- un premier module de traitement chargé i) de constituer une première représentation d'une image de tenseurs reçue, ii) d'appeler le premier module de calcul pour appliquer la première fonction à une partie choisie de la première représentation, de manière à obtenir une partie transformée, et iii) de constituer à partir de la partie transformée une seconde représentation de l'image de tenseurs pouvant être traitée.

Le premier dispositif selon l'invention peut comporter d'autres caractéristiques qui peuvent être prises séparément ou en combinaison, et notamment :

- son premier module de traitement peut être chargé i) de constituer chaque première représentation sous la forme d'un produit d'une première matrice orthogonale, d'une matrice diagonale, constituée de coefficients et constituant la partie choisie, et d'une seconde matrice orthogonale, transposée de la première, ii) d'appeler le premier module de calcul afin qu'il applique à chacun des coefficients situés sur la diagonale de la matrice diagonale la première fonction choisie, de manière à obtenir une matrice diagonale transformée constituant la partie transformée, et iii) d'effectuer un produit entre la première matrice orthogonale, la matrice diagonale transformée et la seconde matrice orthogonale, afin de délivrer une matrice finale symétrique au moins représentative de la seconde représentation ;
- la matrice finale symétrique peut directement constituer la seconde représentation. Dans une variante, le premier module de traitement peut être chargé de transformer la matrice finale symétrique de dimension n*n en un vecteur de dimension n(n+1)/2 qui constitue alors la seconde représentation ;
- il peut comprendre un deuxième module de traitement chargé d'appliquer au moins un traitement choisi à la seconde représentation de l'image de tenseurs reçue, afin de délivrer une troisième représentation traitée de l'image de tenseurs reçue ;

  ➢ le deuxième module de traitement peut alors être chargé d'appliquer au moins un traitement vectoriel ou matriciel choisi à la seconde représentation ;
  ➢ il peut également comprendre, d'une part, un second module de calcul, chargé de mettre en oeuvre une seconde fonction choisie, bijective et associée à la définition de métrique choisie, cette seconde fonction étant la fonction réciproque de la première fonction, et d'autre part, un troisième module de traitement chargé i) de constituer une quatrième représentation de l'image de tenseurs reçue à partir de la troisième représentation, ii) d'appeler le second module de calcul pour appliquer la seconde fonction à une partie choisie de la quatrième représentation, afin de transformer cette partie en une partie transformée, et iii) de constituer une image de tenseurs traitée à partir de la partie transformée ;

    • en présence d'une troisième représentation sous forme vectorielle, le troisième module de traitement peut être chargé i) de transformer cette troisième représentation en une matrice intermédiaire symétrique de dimension n*n, ii) de décomposer la matrice intermédiaire symétrique en un produit d'une troisième matrice orthogonale, d'une matrice diagonale, constituée de coefficients et constituant la partie choisie, et d'une quatrième matrice orthogonale, transposée de la troisième, iii) d'appeler le second module de calcul pour appliquer la seconde fonction choisie à chacun des coefficients situés sur la diagonale de cette matrice diagonale, afin d'obtenir une matrice diagonale transformée constituant la partie transformée, et iv) d'effectuer un produit entre la première matrice orthogonale, la matrice diagonale transformée et la seconde matrice orthogonale, afin de délivrer l'image de tenseurs traitée ;
    • en variante, c'est-à-dire en présence d'une troisième représentation sous la forme d'une matrice intermédiaire symétrique de dimension n*n, le troisième module de traitement peut être chargé i) de décomposer la matrice intermédiaire symétrique en un produit d'une troisième matrice orthogonale, d'une matrice diagonale, constituée de coefficients et constituant la partie choisie, et d'une quatrième matrice orthogonale, transposée de la troisième, ii) d'appeler le second module de calcul pour appliquer la seconde fonction choisie à chacun des coefficients situés sur la diagonale de cette matrice diagonale, afin d'obtenir une matrice diagonale transformée constituant la partie transformée, et iii) d'effectuer un produit entre la première matrice orthogonale, la matrice diagonale transformée et la seconde matrice orthogonale, afin de délivrer l'image de tenseurs traitée ;

- son premier module de calcul peut être chargé d'appliquer une première fonction à base logarithmique ;

  ➢ par exemple, la première fonction à base logarithmique est la fonction logarithme népérien (log) qui est associée à la seconde fonction réciproque exponentielle (exp) ;

➢ en variante, la première fonction à base logarithmique peut être la fonction logarithme de base a ($\log_a$), avec $a \neq e$, laquelle est associée à la seconde fonction réciproque exponentielle de base a ($a^x = e^{x\log a}$).

L'invention propose également un second dispositif dédié au traitement de données constituant une première représentation traitée d'une image initiale (brute ou de tenseurs). Ce second dispositif se caractérise par le fait qu'il comprend :

- un module de calcul chargé de mettre en oeuvre une (seconde) fonction choisie, bijective et associée à la définition d'une métrique choisie, et
- un module de traitement chargé i) de constituer une deuxième représentation traitée de l'image initiale à partir de la première représentation traitée, ii) d'appeler le module de calcul pour appliquer la (seconde) fonction à une partie choisie de la deuxième représentation traitée, de manière à transformer cette partie en une partie transformée, et iii) de constituer une image de tenseurs traitée à partir de cette partie transformée.

Le second dispositif selon l'invention peut comporter d'autres caractéristiques qui peuvent être prises séparément ou en combinaison, et notamment :

- en présence d'une première représentation traitée sous forme vectorielle, son module de traitement peut être chargé i) de transformer la première représentation traitée en une matrice intermédiaire symétrique de dimension n*n, ii) de décomposer cette matrice intermédiaire symétrique en un produit d'une première matrice orthogonale, d'une matrice diagonale, constituée de coefficients et constituant la partie choisie, et d'une seconde matrice orthogonale, transposée de la première, iii) d'appeler le module de calcul pour appliquer la (seconde) fonction choisie à chacun des coefficients situés sur la diagonale de la matrice diagonale, afin d'obtenir une matrice diagonale transformée constituant la partie transformée, puis iv) d'effectuer un produit entre la première matrice orthogonale, la matrice diagonale transformée et la seconde matrice orthogonale, afin de délivrer l'image de tenseurs traitée ;
- en variante, c'est-à-dire en présence d'une première représentation traitée sous la forme d'une matrice intermédiaire symétrique de dimension n*n, le module de traitement peut être chargé i) de décomposer la matrice intermédiaire symétrique en un produit d'une première matrice orthogonale, d'une matrice diagonale, constituée de coefficients et constituant la partie choisie, et d'une seconde matrice orthogonale, transposée de la première, ii) d'appeler le module de calcul pour appliquer la (seconde) fonction choisie à chacun des coefficients situés sur la diagonale de cette matrice diagonale, afin d'obtenir une matrice diagonale transformée constituant la partie transformée, et iii) d'effectuer un produit entre la première matrice orthogonale, la matrice diagonale transformée et la seconde matrice orthogonale, afin de délivrer l'image de tenseurs traitée ;
- son module de calcul peut être chargé d'appliquer une (seconde) fonction exponentielle de base a choisie ;

➢ par exemple la (seconde) fonction exponentielle est la fonction exponentielle de base a = e qui est la réciproque de la (première) fonction logarithme népérien (log) ;
➢ dans une variante, la (seconde) fonction exponentielle peut être la fonction exponentielle de base $a \neq e$ ($a^x = e^{x\log a}$) qui est la réciproque de la (première) fonction logarithme de base a ($\log_a$) ;
➢ la première représentation traitée peut résulter de l'application d'au moins un traitement choisi à une représentation intermédiaire (la deuxième représentation délivrée par le premier dispositif) résultant elle-même de l'application à une partie choisie d'une représentation antérieure (la première représentation délivrée par le premier dispositif) d'une image de tenseurs initiale d'une autre (première) fonction choisie, bijective, définie de l'espace $R^{*+}$ dans l'espace R, et associée à la définition de métrique choisie, cette autre (première) fonction étant la réciproque de la (seconde) fonction ;
➢ il peut comprendre un deuxième module de traitement chargé d'appliquer au moins un traitement choisi aux données représentatives d'une image initiale brute, de manière à délivrer la première représentation traitée. Par exemple, le deuxième module de traitement peut être chargé d'appliquer un traitement vectoriel choisi aux données représentatives de l'image initiale brute.

L'invention propose également un procédé dédié, tout comme le premier dispositif présenté ci-avant, au traitement de données constituant des images initiales (brutes ou de tenseurs). Ce procédé reprend toutes les fonctionnalités principales et optionnelles mises en oeuvre par le premier dispositif de traitement et/ou le second dispositif de traitement.
L'invention est particulièrement bien adaptée, bien que de façon non exclusive, aux traitements d'images initiales (brutes ou de tenseurs), notamment de diffusion, dans le domaine médical.
D'autres caractéristiques et avantages de l'invention apparaîtront à l'examen de la description détaillée ci-après, et des dessins annexés, sur lesquels :

- la figure 1 illustre de façon très schématique et fonctionnelle un exemple de réalisation d'un premier dispositif de traitement selon l'invention,
- la figure 2 illustre de façon très schématique et fonctionnelle un exemple de réalisation d'un second dispositif de traitement selon l'invention, alimenté par une variante du premier dispositif de traitement de la figure 1,
- la figure 3 illustre une image de quatre tenseurs dans un cas synthétique,
- les figures 4 et 5 illustrent les résultats d'une interpolation bilinéaire appliquée à l'image de la figure 3 en présence de traitements respectivement dans le cadre Euclidien et dans le cadre Log-Euclidien,
- la figure 6 illustre les résultats d'un ré-échantillonnage par interpolation bilinéaire, obtenus respectivement avec les métriques Euclidienne et Log-Euclidienne, dans le cas d'une coupe de corps calleux obtenue selon la technique DT-MRI réelle,
- la figure 7 illustre les résultats d'un filtrage anisotrope d'une image synthétique bruitée, obtenus avec les métriques Euclidienne et Log-Euclidienne,
- la figure 8 illustre les résultats d'un filtrage anisotrope sur une coupe de DT-MRI avec les métriques Euclidienne et Log-Euclidienne,
- les figures 9A et 9B illustrent les résultats d'un suivi de fibres dans la matière blanche du cerveau humain respectivement sans traitement préalable et après traitement (ré-echantillonnage et régularisation) avec la métrique Log-Euclidienne,
- la figure 10 illustre de façon très schématique et fonctionnelle une première variante de réalisation d'un second dispositif de traitement selon l'invention, et
- la figure 11 illustre de façon très schématique et fonctionnelle une seconde variante de réalisation d'un second dispositif de traitement selon l'invention.

Les dessins annexés pourront non seulement servir à compléter l'invention, mais aussi contribuer à sa définition, le cas échéant.

L'invention a pour objet de permettre le traitement d'images initiales, brutes ou de tenseurs, éventuellement bruitées. Tout type d'image initiale bi ou tri-dimensionnelle est ici concerné, et notamment les images médicales, par exemple de type DT-MRI ou de tenseurs d'élasticité (permettant par exemple d'extraire le module de Young en chaque point pour classer des tumeurs de types différents), les images de turbulences en mécanique des fluides et les images dans le domaine des ultrasons, les images de « métriques » (appellation des tenseurs utilisée par l'homme de l'art dans ce cas) utilisées par exemple pour affiner ou adapter des maillages d'aires, de surfaces ou de volumes (notamment afin d'accélérer les traitements d'image intéressant la résolution numérique d'équations aux dérivées partielles).

Par ailleurs, l'invention concerne tout type de traitement d'image initiale (brute ou de tenseurs), et notamment le débruitage par filtrage (éventuellement vectoriel) de nature à faciliter tout type de traitement complémentaire postérieur, l'interpolation ou l'extrapolation (pour reconstituer de l'information manquante à partir d'informations de départ, par exemple pour obtenir des images de meilleure résolution dans des coupes intermédiaires), la segmentation (par exemple pour effectuer une classification de composantes ou régions différentes ou de types de matériaux différents), le groupement, l'analyse de mouvement(s), la segmentation de texture, la modélisation de variations (éventuellement anatomiques), la reconstruction de la connectivité de la matière blanche dans le cerveau ou de connexions cérébrales, ou l'obtention de statistiques sur des résultats de recalages (ces statistiques pouvant ultérieurement être utilisées comme *a priori* sur la variabilité anatomique).

L'invention propose d'utiliser un nouveau cadre Riemannien surmontant les inconvénients du cadre Riemannien affine-invariant. Ce nouveau cadre offre un espace de courbure nulle et une nouvelle métrique qui permettent de réduire la complexité des calculs quasiment au niveau du cadre Euclidien.

Les informations théoriques nécessaires à la compréhension par l'homme de l'art de ce nouveau cadre Riemannien sont résumées ci-après.

A chaque tenseur S est associé un unique logarithme L tel que S = exp(L), où exp est l'exponentielle de matrices. Ce logarithme est simplement une matrice symétrique quelconque, et inversement à toute matrice symétrique correspond un unique tenseur donné par l'exponentielle de cette matrice. Dans une base orthonormale dans laquelle S est diagonale, L est obtenu simplement en transformant les valeurs propres de S en leur logarithme standard, par exemple népérien.

On décrit ci-après le cadre théorique dans une application au logarithme népérien « log » et à sa fonction réciproque exponentielle « exp ». Dans cette application, on appellera la métrique « Log-Euclidienne ». Mais ce cadre n'est pas limité aux fonctions log et exp. Il s'applique aux fonctions à base logarithmique, et notamment aux logarithmes de base a quelconque et leurs réciproques les exponentielles de base a quelconque, ainsi qu'à d'autres types de fonctions, comme par exemple la fonction « - log » ou les fonctions translatées des logarithmes de base a quelconque « C +/- $\log_a$ » où C est une constante.

Puisqu'il existe une bijection entre l'espace des tenseurs, noté Sym*+(n), et celui des matrices symétriques, noté Sym(n), on peut donner à Sym*+(n) une structure d'espace vectoriel en transportant l'addition (+) et la multiplication scalaire (.) avec l'exponentielle de matrices.

Ceci définit sur Sym\*\*(n) le produit logarithmique $\odot$ et la multiplication scalaire logarithmique $\circledast$, donnés par :

$$S_1 \odot S_2 := \exp(\log(S_1) + \log(S_2))$$

$$\lambda \circledast S := \exp(\lambda.\log(S)) = S^\lambda$$

Le produit logarithmique est commutatif et coïncide avec la multiplication matricielle quand les deux tenseurs $S_1$ et $S_2$ commutent au sens de la multiplication matricielle standard.

Avec $\odot$ et $\circledast$, l'espace des tenseurs possède par construction une structure d'espace vectoriel. On peut noter que cette structure n'est pas la structure habituelle provenant de l'addition et de la multiplication scalaire définies usuellement sur les matrices carrées. Avec cette dernière, l'espace des tenseurs n'est pas un espace vectoriel, alors qu'avec les opérations logarithmiques précitées, l'espace des tenseurs est un espace vectoriel. La notion d'espace vectoriel dépend de la structure qui est considérée et non directement de l'espace lui-même.

Lorsque l'on considère uniquement la multiplication $\odot$ sur l'espace des tenseurs, on obtient ce que l'on appelle un groupe de Lie, c'est-à-dire un espace qui est à la fois une variété différentielle et un groupe dans lequel les opérations algébriques sont les applications régulières. Ce point de vue est important, car la théorie des métriques Riemanniennes peut être mise à profit dans le cas des groupes de Lie pour définir des métriques, c'est-à-dire des distances, dans un cadre où les outils habituels d'analyse et de statistiques peuvent être généralisés, comme indiqué dans le document de X. Pennec « Probabilities and Statistics on Riemannian Manifolds : A Geometric approach », Research Report 5093, INRIA, January 2004.

Parmi les métriques Riemanniennes dans les groupes de Lie, les plus pratiques, lorsqu'elles existent, sont les métriques bi-invariantes, c'est-à-dire les distances qui sont invariantes par multiplication et inversion. Pour le groupe de Lie des tenseurs, ces métriques bi-invariantes existent et sont particulièrement simples. Comme indiqué ci-avant, elles peuvent être appelées Log-Euclidiennes, puisqu'elles correspondent à des métriques Euclidiennes dans le domaine logarithmique. A partir d'une norme Euclidienne ||.|| sur Sym(n), elles s'écrivent :

$$d(S_1, S_2) = \| \log(S_1) - \log(S_2) \| \qquad (1)$$

Contrairement au cadre Euclidien classique pour les tenseurs, on peut observer à partir de l'équation (1) que les matrices symétriques avec des valeurs propres négatives ou nulles sont à une distance infinie des tenseurs et en pratique n'apparaissent pas dans les calculs.

De plus, les distances Log-Euclidiennes sont invariantes par inversion : le principe de symétrie entre un tenseur et son inverse est vérifié. En conséquence, la moyenne Log-Euclidienne de tenseurs est une généralisation de la moyenne géométrique et non de la moyenne arithmétique donnée par le cadre Euclidien classique. En particulier, la moyenne Log-Euclidienne d'un tenseur et de son inverse est l'identité. Ceci est crucial notamment pour obtenir une interpolation correcte des déterminants lorsque deux tenseurs sont interpolés.

Parmi toutes les métriques Log-Euclidiennes sur l'espace des tenseurs, certaines d'entre elles sont invariantes par similitude (rotation plus facteur d'échelle). Ceci signifie que si les tenseurs sont des matrices de covariance, les calculs menés sur eux avec une telle métrique seront invariants si l'on change de système de coordonnées via une similitude. Un exemple de métrique invariante par similitude est donnée par :

$$d(S_1, S_2) = (\text{Trace}(\{\log(S_1) - \log(S_2)\}^2))^{1/2}$$

L'espace vectoriel des tenseurs muni d'une métrique Log-Euclidienne est isomorphe et isométrique avec l'espace Euclidien correspondant des matrices symétriques. En conséquence, le cadre Riemannien pour les statistiques et l'analyse est extrêmement simplifié, bien plus que dans le cas des métriques affine-invariantes. En particulier, la moyenne Log-Euclidienne de N tenseurs est donnée par :

$$E_{LE}(S_1,...,S_N)=\exp\left(\frac{1}{N}\sum_{i=1}^{N}\log(S_i)\right)$$

Grâce à cela, l'interpolation, l'extrapolation, la diffusion anisotrope, et plus généralement les différents traitements effectués sur les tenseurs peuvent simplement être effectués uniquement dans le domaine logarithmique de façon Euclidienne et les résultats finaux peuvent être transposés dans le domaine tensoriel avec l'exponentielle de matrice. De cette manière, les outils statistiques ou analytiques habituels (par exemple pour les statistiques l'Analyse en Composantes Principales ou ACP et pour l'analyse les Equations aux Dérivées Partielles ou EDPs) sont généralisés immédiatement aux tenseurs. L'existence et l'unicité de telles EDPs sur les tenseurs se ramènent alors à des cas particuliers de la théorie classique des EDPs sur les champs de vecteurs.

Dans la pratique, on s'aperçoit que les métriques Log-Euclidiennes et affine-invariantes donnent des résultats très proches dans des applications telles que le ré-échantillonnage, l'extrapolation dense de données éparses ou le filtrage anisotrope. La différence principale réside dans l'anisotropie légèrement plus marquée pour les résultats obtenus avec une métrique Log-Euclidienne. En revanche, il y a des différences considérables en termes de temps de calcul et de simplicité d'implémentation. En effet, les calculs effectués avec une métrique Log-Euclidienne sont plus rapides que ceux effectués avec une métrique affine-invariante d'un facteur au moins égal à 6 dans certaines applications. De plus, les calculs effectués avec une métrique Log-Euclidienne sont de simples calculs Euclidiens dans le domaine logarithmique, et ne font pas appel à des corrections de type courbure comme dans le cas affine-invariant.

L'invention propose un (premier) dispositif destiné à traiter des données constituant des images de tenseurs initiales, et notamment à faciliter leur traitement par une ou plusieurs fonctions de traitement, avant un (ou plusieurs) éventuel(s) traitement(s) complémentaire(s).

On entend ici par « faciliter » le fait d'avoir un cadre mathématique simple dans lequel, par exemple, les statistiques sont simplement des statistiques sur des vecteurs. Du point de vue de l'analyse, ce cadre vectoriel permet de faire intervenir une dépendance entre des tenseurs voisins d'une image de tenseurs de façon vectorielle et donc très simple, en vue, par exemple, de réduire le bruit qui corrompt les images tout en conservant les informations d'anisotropie qu'elles contiennent.

Le (premier) dispositif de traitement D peut faire partie d'un équipement d'acquisition d'images de tenseurs (ou imageur) ou bien être implanté dans un ordinateur destiné à traiter des images de tenseurs délivrées par un imageur.

On considère dans ce qui suit, à titre d'exemple illustratif, que le dispositif D reçoit des images de tenseurs de type DT-MRI constituées chacune à partir d'images brutes consistant en une image dite de base et six images acquises suivant six directions différentes et représentatives, ici, de la diffusion de molécules d'eau dans ces six directions pour un même b-facteur. L'image de base est une IRM T2 (image par résonance magnétique) acquise avec les mêmes paramètres que les images de diffusion (avec un b-facteur nul, cette fois-ci). Le processus de diffusion entraîne une diminution du signal en chacune des images de diffusion par rapport à l'image de base. Cette diminution dépend directement du tenseur de diffusion en chaque partie élémentaire des images.

Chaque image de tenseurs est donc constituée d'un ensemble de tenseurs définis chacun en une partie élémentaire de position connue au sein d'une grille bi ou tri-dimensionnelle. Il est rappelé qu'un tenseur est une matrice réelle symétrique et définie positive.

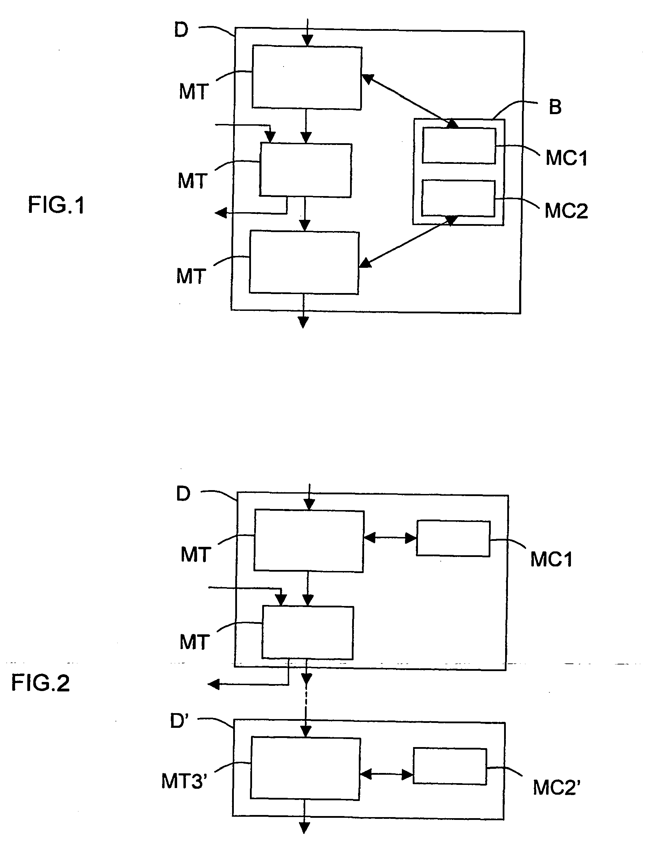

Un exemple de réalisation, schématique et fonctionnel, d'un (premier) dispositif de traitement D, selon l'invention, est illustré sur la figure 1.

Ce dispositif de traitement D comprend au moins un (premier) module de calcul MC1 couplé à un (premier) module de traitement MT1.

Le premier module de calcul MC1 est chargé de mettre en oeuvre une première fonction choisie, bijective, définie de l'espace des réels positifs et non nuls (R**+) dans l'espace des réels (R), (c'est-à-dire de ]0, +∞ [ vers ]-∞, +∞ [), et associée à une métrique du type de celle présentée ci-avant dans le cadre du résumé théorique du nouveau cadre Riemannien (relation (1)). Par ailleurs, cette première fonction doit admettre une seconde fonction réciproque.

Il est important de noter que les calculs étant effectués par des ordinateurs, -∞ et +∞ sont respectivement les plus petite et plus grande valeurs que peut atteindre l'ordinateur.

Par ailleurs, les première et seconde fonctions étant mises en oeuvre par des ordinateurs, elles sont dans la pratique des approximations de fonctions idéales. Par conséquent, on entend ici par première ou seconde fonction une approximation d'une première ou seconde fonction idéale. De même, on entend ici par « fonction bijective » une fonction idéalement bijective ou approximativement bijective. En outre, on entend ici par « fonction réciproque » une fonction idéalement réciproque ou approximativement réciproque.

Par exemple, la première fonction choisie est une approximation d'une fonction idéale de type logarithme de base a (fonction transformant un produit en une somme). Par exemple, il peut s'agir du logarithme de base a = e (2,71828...), appelé logarithme népérien « log », qui est associé à la (seconde) fonction idéale réciproque appelée exponentielle de néper « exp ». Il pourrait également s'agir du logarithme de base a « log$_a$ », avec a ≠ e, qui est associé à la (seconde) fonction idéale réciproque appelée exponentielle de base a « a$^x$= e$^{x\log a}$ ».

Le passage du logarithme népérien au logarithme de base a (a ≠ e) ne fait qu'introduire un facteur d'échelle au niveau de la métrique donnée par la relation (1) d(S$_1$, S$_2$) = ||log(S$_1$)-log(S$_2$)||, où S$_i$ (i=1,2) représente un tenseur et « log » représente la fonction logarithme népérien appliquée à une matrice.

Il est important de noter que l'invention n'est pas limitée aux seules (premières) fonctions logarithmiques. Elle s'applique à toute (première) fonction choisie, bijective, définie de l'espace R$^{*+}$ dans l'espace R , et associée à une définition de métrique choisie.

On considère dans ce qui suit que la première fonction, mise en oeuvre par le premier module de calcul MC1, est le logarithme népérien (log).

Le premier module de calcul MC1 peut par exemple faire partie d'une bibliothèque mathématique d'opérateurs et de fonctions B.

Le premier module de traitement MT1 est chargé d'effectuer trois opérations.

La première opération consiste à transformer chaque image de tenseurs (initiale, éventuellement bruitée) qu'il reçoit en une première représentation R1.

La deuxième opération consiste à appeler le premier module de calcul MC1 pour appliquer la première fonction (ici « log ») à une partie choisie de la première représentation R1, lui permettant ainsi de transformer cette partie choisie en une partie transformée.

La troisième opération consiste à partir de la partie transformée pour constituer une seconde représentation R2 de l'image de tenseurs (initiale) reçue. C'est cette seconde représentation R2 qui facilite le traitement (par exemple le débruitage) par au moins une fonction de traitement (par exemple de filtrage) de l'image de tenseurs (initiale) reçue du fait de sa nature vectorielle.

Par exemple, lors de la première opération le premier module de traitement MT1 transforme chaque image de tenseurs en une première représentation R1 sous la forme d'un produit d'une première matrice orthogonale M$_R$, d'une matrice diagonale M$_D$ et d'une seconde matrice orthogonale M$^t_R$, transposée de la première M$_R$. A cet effet, on peut par exemple utiliser une routine LAPACK (« Linear Algebra PACKage » - ensemble de routines en Fortran 77 pour l'algèbre linéaire), telle que DYSERV. Cette première représentation peut se réécrire : R1 = M$_R$. M$_D$ . M$^t_R$, avec

$$M_D = \begin{pmatrix} C_{11} & 0 & 0 \\ 0 & C_{22} & 0 \\ 0 & 0 & C_{33} \end{pmatrix}$$, matrice diagonale de n*n nombres (ici n = 3) où les Cii (i=1 à 3) sont les coefficients situés sur la diagonale et où tous les coefficients Cij (avec i ≠ j), situés hors de la diagonale, sont nuls.

Il est rappelé qu'une matrice orthogonale M$_R$ est une matrice de n*n nombres, telle que M$_R$ .M$^t_R$ =Id où Id est la matrice n*n identité, c'est-à-dire avec des coefficients égaux a1 sur la diagonale et des coefficients nuls ailleurs.

Dans ce cas, lors de la deuxième opération le premier module de traitement MT1 transforme la matrice diagonale M$_D$ (partie choisie) en une matrice diagonale transformée M'$_D$ (partie transformée) au moyen de la première fonction (ici « log ») du premier module de calcul MC1 :

$$M'_D = \begin{pmatrix} \log(C_{11}) & 0 & 0 \\ 0 & \log(C_{22}) & 0 \\ 0 & 0 & \log(C_{33}) \end{pmatrix}.$$

Cela revient à appliquer la première fonction log à chaque coefficient Cii situé sur la diagonale de la matrice M$_D$.

Ensuite, lors de la troisième opération le premier module de traitement MT1 effectue le produit entre la première matrice orthogonale M$_R$, la matrice diagonale transformée M'$_D$ et la seconde matrice orthogonale M$^t_R$, afin de délivrer une matrice finale symétrique M$_s$ (de n*n nombres) qui est représentative (au moins) de la seconde représentation R2. Cette matrice finale M$_s$ est symétrique, mais pas définie positive :

$$M_S = \begin{pmatrix} (\log C)_{11} & (\log C)_{12} & (\log C)_{13} \\ (\log C)_{12} & (\log C)_{22} & (\log C)_{23} \\ (\log C)_{13} & (\log C)_{23} & (\log C)_{33} \end{pmatrix}.$$

Si un traitement matriciel (par exemple une fonction de filtrage matriciel) est prévu après l'obtention de la matrice finale symétrique $M_S$, cette dernière constitue la seconde représentation R2 de l'image de tenseurs (initiale) reçue, prête à être traitée (par exemple filtrée). En revanche, si un traitement vectoriel (par exemple une fonction de filtrage vectoriel) est prévu après l'obtention de la matrice finale symétrique $M_S$, le module de traitement MT1 procède à la transformation de la matrice finale symétrique $M_S$ en un vecteur V de dimension n(n+1)/2 qui constitue alors la seconde représentation R2 de l'image de tenseurs (initiale) reçue, prête à être filtrée, donnée par exemple mais non exclusivement par:

$$V := (\log C)_{11}, (\log C)_{22}, (\log C)_{33}, \sqrt{2} * (\log C)_{12}, \sqrt{2} * (\log C)_{13}, \sqrt{2} * (\log C)_{23})^T \quad (2)$$

On peut également utiliser d'autres variantes, et notamment toutes les combinaisons linéaires non-singulières des coefficients du vecteur défini par l'équation (2).

Comme cela est illustré sur la figure 1, le dispositif de traitement D peut également comporter un deuxième module de traitement MT2 chargé d'appliquer au moins une fonction de traitement (par exemple un filtrage) choisi à la seconde représentation R2 (de l'image de tenseurs (initiale) reçue), délivrée par le premier module de traitement MT1.

Tout type de traitement matriciel ou vectoriel peut être envisagé selon que la représentation R2 se présente sous la forme d'une matrice finale symétrique $M_S$ ou d'un vecteur V. Parmi les différents traitements matriciels qui peuvent être envisagés, on peut notamment citer tous les traitements vectoriels dans lesquels on traite les matrices comme des vecteurs ou bien les traitements matriciels présentés dans le document de J. Weickert et al. « Diffusion and Regularization of Vector- and Matrix-Valued Images », Preprint No 58, Universität des Saarlandes, Saarbrücken 2002. Parmi les différents traitements vectoriels qui peuvent être envisagés, on peut notamment citer les filtres anisotropes présentés dans l'article de Gerig et al. « Non-Linear Anisotropic Filtering of MRI Data », IEEE Transactions in Medical Imaging, 11 (2) : 221-232, Juin 1992.

Le deuxième module de traitement MT2 délivre en sortie une troisième représentation R3, traitée, de l'image de tenseurs (initiale) reçue. Cette troisième représentation R3 se présente sous la forme d'une matrice filtrée $M_F$ ou d'un vecteur filtré $V_F$, selon que la seconde représentation R2 se présente sous la forme d'une matrice finale symétrique $M_S$ ou d'un vecteur V.

Comme cela est illustré sur les figures 1 et 2, le deuxième module de traitement MT2 peut comporter une entrée complémentaire permettant, par exemple, de guider le ou les traitements qu'il est chargé d'appliquer à la seconde représentation R2.

En variante ou en complément, et comme cela est illustré sur les figures 1 et 2, le deuxième module de traitement MT2 peut également comporter une sortie complémentaire permettant de délivrer des données différentes des troisièmes représentations R3 (image de vecteurs ou de matrices symétriques), mais présentant une relation avec ces dernières. Par exemple, il peut délivrer des données représentatives d'une image de nombres permettant de répartir les voxels d'une image en n classes.

Afin de revenir au format initial de l'image de tenseurs, qui peut faire l'objet de nombreux traitements connus, le dispositif de traitement D comporte un troisième module de traitement MT3 couplé à un second module de calcul MC2.

Le second module de calcul MC2 est chargé de mettre en oeuvre la seconde fonction, réciproque de la première fonction mise en oeuvre par le premier module de calcul MC1. En raison des propriétés de la première fonction, cette seconde fonction est bijective et associée à la définition de métrique choisie.

Comme indiqué précédemment, lorsque la première fonction est le logarithme népérien « log », la seconde fonction est l'exponentielle de néper « exp ».

Le second module de calcul MC2 peut par exemple faire partie d'une bibliothèque mathématique d'opérateurs et de fonctions B.

Le troisième module de traitement MT3 est chargé d'effectuer au moins trois opérations.

La première opération consiste à constituer une quatrième représentation R4 (traitée) de l'image de tenseurs (initiale) reçue, à partir de la troisième représentation R3 délivrée par le deuxième module de traitement MT2.

La deuxième opération consiste à appeler le second module de calcul MC2 pour appliquer la seconde fonction (ici « exp ») à une partie choisie de la quatrième représentation R4, lui permettant ainsi d'obtenir une partie transformée.

La troisième opération consiste à constituer une image de tenseurs traitée à partir de la partie transformée.

Par exemple, lors de la première opération le troisième module de traitement MT3 transforme la matrice filtrée $M_F$ (ou R3) en un produit d'une troisième matrice orthogonale $M'_R$, d'une matrice diagonale filtrée $M_{DF}$ et d'une quatrième matrice orthogonale $M'^t_R$, transposée de la troisième $M'_R$, afin d'obtenir la quatrième représentation R4 (traitée). A cet effet, on peut par exemple utiliser une routine LAPACK, telle que DYSERV. Cette quatrième représentation R4 (traitée) peut se réécrire : R4 = $M'_R$ . $M_{DF}$ . $M'^t_R$.

La matrice diagonale filtrée $M_{DF}$ est donnée par : $M_{DF} = \begin{pmatrix} C'_{11} & 0 & 0 \\ 0 & C'_{22} & 0 \\ 0 & 0 & C'_{33} \end{pmatrix}$, où les coefficients $C'_{ii}$ sont les valeurs propres de la matrice filtrée $M_F$.

Bien entendu, lorsque la troisième représentation R3, délivrée par le deuxième module de traitement MT2, se présente sous la forme d'un vecteur filtré $V_F$ et non d'une matrice filtrée $M_F$, le troisième module de traitement MT3 transforme le vecteur filtré $V_F$ en une matrice intermédiaire symétrique (ou matrice filtrée $M_F$) de dimension n*n.

Dans l'exemple précité, lors de la deuxième opération le troisième module de traitement MT3 transforme la matrice diagonale filtrée $M_{DF}$ (partie choisie) en une matrice diagonale filtrée et transformée $M'_{DF}$ (partie transformée) au moyen de la seconde fonction (ici « exp ») du second module de calcul MC2 :

$$M'_{DF} = \begin{pmatrix} e^{C'_{11}} & 0 & 0 \\ 0 & e^{C'_{22}} & 0 \\ 0 & 0 & e^{C'_{33}} \end{pmatrix}.$$

Cela revient à appliquer la seconde fonction exp à chaque coefficient $C'_{ii}$ situé sur la diagonale de la matrice $M_{DF}$.

Ensuite, lors de la troisième opération le troisième module de traitement MT3 effectue le produit entre la troisième matrice orthogonale $M'_R$, la matrice diagonale transformée $M'_{DF}$ et la quatrième matrice orthogonale $M'^t_R$, afin de délivrer une image de tenseurs traitée ($M'_R$ . $M'_{DF}$ . $M'^t_R$).

Cette image de tenseurs traitée peut alors faire l'objet de nombreux traitements complémentaires connus, notamment et non exclusivement lorsque le traitement effectué par le deuxième module de traitement MT2 consiste en un débruitage par filtrage. Parmi ces traitements complémentaires on peut par exemple citer l'interpolation, l'extrapolation, la segmentation, le groupement, l'analyse de mouvement(s), la segmentation de texture, la modélisation de variations (éventuellement anatomiques), la détection de reconstruction de connectivité(s) de la matière blanche dans le cerveau ou de connexions cérébrales, ou l'obtention de statistiques sur des résultats de recalages.

L'invention concerne également un (second) dispositif de traitement D' destiné exclusivement à faire revenir au format initial d'une image de tenseurs des données représentatives de la troisième représentation R3, délivrée par le deuxième module de traitement MT2.

Il est important de noter que le (premier) dispositif de traitement D présenté ci-avant peut, dans une variante, ne comporter qu'un premier module de calcul MC1 et des premier et deuxième modules de traitement MT1 et MT2, comme illustré sur la figure 2. Dans ce cas, le deuxième module de traitement MT2 délivre des données représentatives de la troisième représentation R3 qui peuvent être stockées en vue de recevoir un traitement complémentaire permettant de les faire revenir au format initial de l'image de tenseurs qu'elles représentent.

Dans ce cas, il faut prévoir un (second) dispositif de traitement D' destiné exclusivement à faire revenir au format initial d'une image de tenseurs des données représentatives de la troisième représentation R3, délivrée par le deuxième module de traitement MT2.

Un tel (second) dispositif de traitement D' est illustré sur la figure 2, à titre d'exemple. Il est en fait constitué d'un (second) module de calcul MC2' et d'un (troisième) module de traitement MT3', respectivement identiques au second module de calcul MC2 et au troisième module de traitement MT3 du (premier) dispositif de traitement D illustré sur la figure 1. Les fonctionnements de ces deux modules MC2' et MT3' étant respectivement identiques à ceux des modules MC2 et MT3, ils ne seront pas de nouveau décrits.

Le (premier) dispositif de traitement D, et notamment son premier module de calcul MC1, son premier module de traitement MT1 et ses éventuels deuxième MT2 et troisième MT3 modules de traitement et deuxième module de calcul MC2, d'une part, et le (second) dispositif de traitement D', et notamment son deuxième module de calcul MC2' et son troisième module de traitement MT3', d'autre part, peuvent être réalisés sous la forme de circuits électroniques, de modules logiciels (ou informatiques), ou d'une combinaison de circuits et de logiciels.

Quelques exemples de traitements pouvant être appliqués à des images de tenseurs initiales au moyen d'un premier D ou second D' dispositif de traitement sont décrits ci-après.

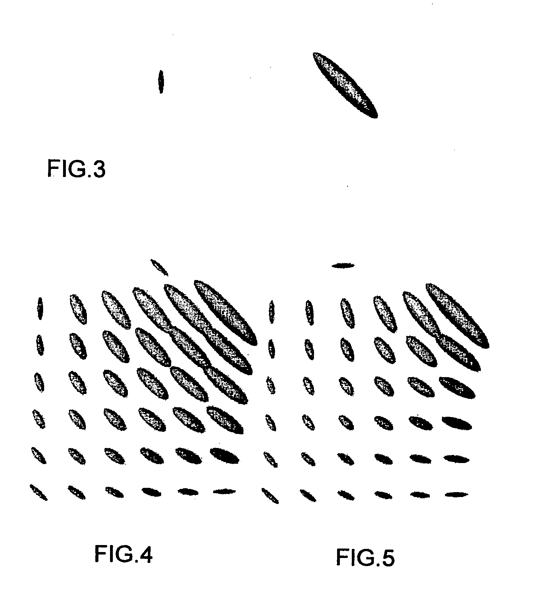

Sur la figure 3 se trouve illustrée une image de quatre tenseurs dans un cas synthétique, et sur les figures 4 et 5 se trouvent illustrés les résultats d'une interpolation bilinéaire appliquée à l'image de la figure 3 en présence de traitements respectivement dans le cadre Euclidien et dans le cadre Log-Euclidien. Comme on peut le constater, un effet de grossissement prononcé apparaît dans le cas Euclidien (figure 4) contrairement au cas Log-Euclidien (figure 5).

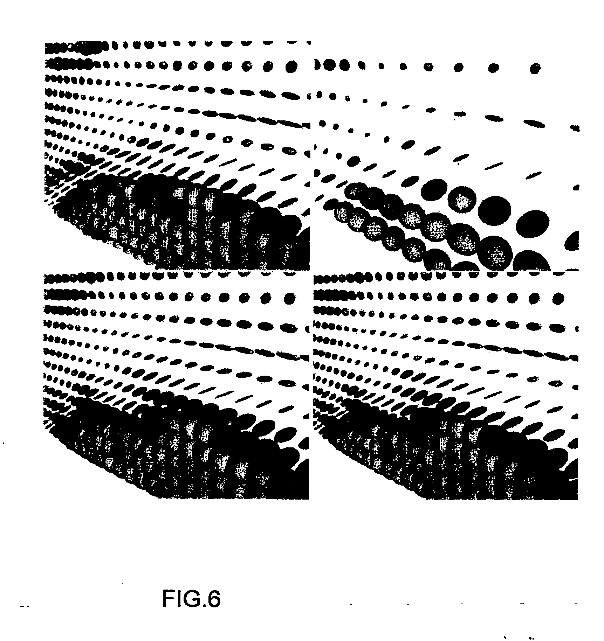

Un autre exemple d'interpolation est présenté sur la figure 6. On utilise une coupe de DT-MRI située dans le plan médian sagittal d'un cerveau humain. Cette coupe est présentée dans une vue en perspective. Le corps calleux et une partie des ventricules y sont visibles. Plus précisément, la partie située en haut à gauche de la figure 6 illustre la coupe initiale, la partie située en haut à droite de la figure 6 illustre le résultat d'un sous-échantillonnage consistant à retirer une ligne sur deux et une colonne sur deux à la coupe initiale, et les parties situées en bas à gauche et en bas à droite de la figure 6 illustrent les résultats d'un ré-échantillonnage par interpolation bilinéaire obtenus respectivement avec les métriques Euclidienne et Log-Euclidienne.

On peut constater une reconstruction de l'anisotropie nettement supérieure dans le cas Log-Euclidien, notamment dans la ligne de tenseurs correspondant au corps calleux juste au-dessus des ventricules. En d'autres termes, la conservation de l'anisotropie est nettement supérieure dans la cas Log-Euclidien.

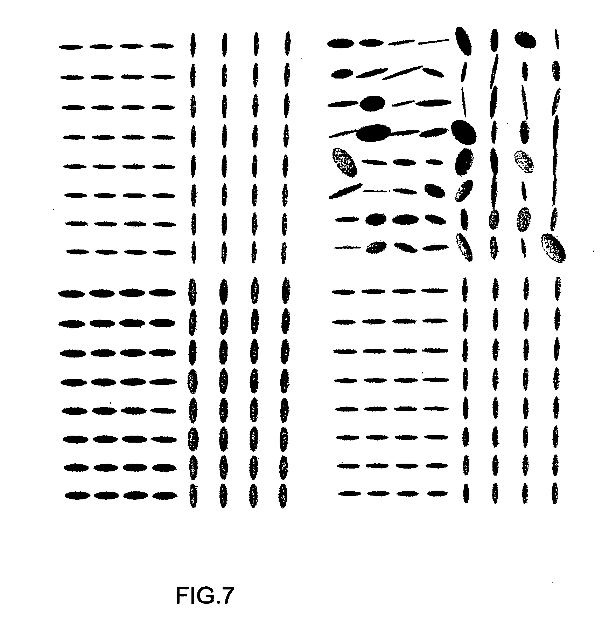

Un autre exemple correspondant à un filtrage anisotrope d'une image synthétique initiale bruitée est illustré sur la figure 7. Plus précisément, la partie située en haut à gauche de la figure 7 illustre l'image synthétique initiale non bruitée, la partie située en haut à droite de la figure 7 illustre l'image synthétique initiale bruitée, et les parties situées en bas à gauche et en bas à droite de la figure 7 illustrent les images filtrées respectivement avec les métriques Euclidienne et Log-Euclidienne.

Plus précisément, dans cet exemple on minimise dans le domaine de l'image une énergie de régularité E(S) donnée par une Φ-fonction :

$$E(S) = \int_{\Omega} \Phi(\|\nabla S\|_{S(x)}(x)) dx,$$

avec $\Phi(s) = \sqrt{\left(1 + \dfrac{s^2}{\kappa^2}\right)}$ et S(x) le champs de tenseurs que l'on filtre.

On minimise cette énergie de régularité E(S) dans les cas Euclidien et Log-Euclidien avec exactement les mêmes paramètres, à savoir un pas de temps dt = 0,01 (schéma numérique explicite standard dans le cas Log-Euclidien, schéma numérique explicite géodésique dans le cas Euclidien), κ = 0,05 et 1000 itérations. Les conditions aux bords retenues sont les conditions de Neumann homogènes.

De nouveau, on peut constater une excellente reconstruction de l'image initiale dans le cas Log-Euclidien et un effet de gonflement typique dans le cas Euclidien.

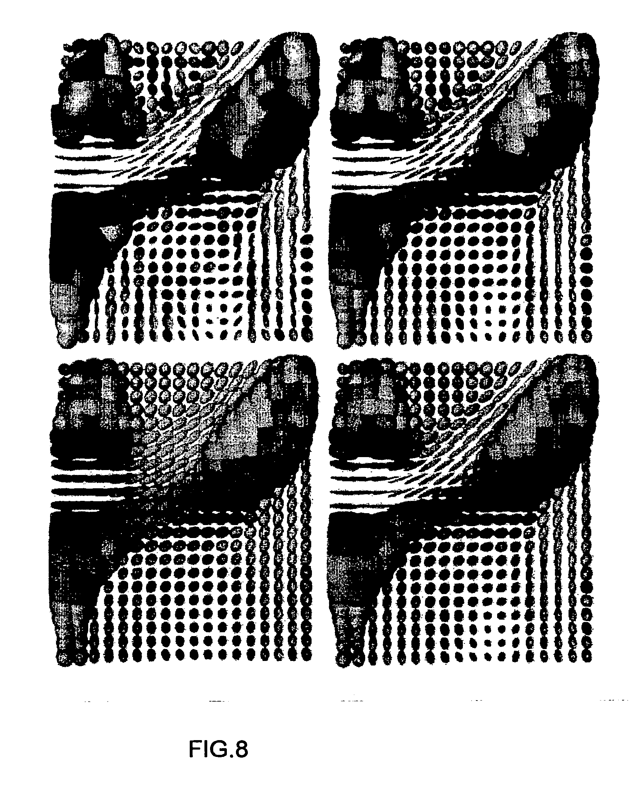

La figure 8 présente les résultats obtenus avec ce même filtrage anisotrope sur une coupe de DT-MRI. Plus précisément, la partie située en haut à gauche de la figure 8 illustre l'image synthétique initiale, la partie située en haut à droite de la figure 8 illustre l'image filtrée avec la métrique Log-Euclidienne pour 500 itérations, et les parties situées en bas à gauche et en bas à droite de la figure 8 illustrent les images filtrées respectivement avec les métriques Euclidienne et Log-Euclidienne pour 1000 itérations.

De nouveau, on peut constater un fort gonflement dans le cas Euclidien et un filtrage très satisfaisant en Log-Euclidien, montrant que le bruit est atténué tout en préservant les structures.

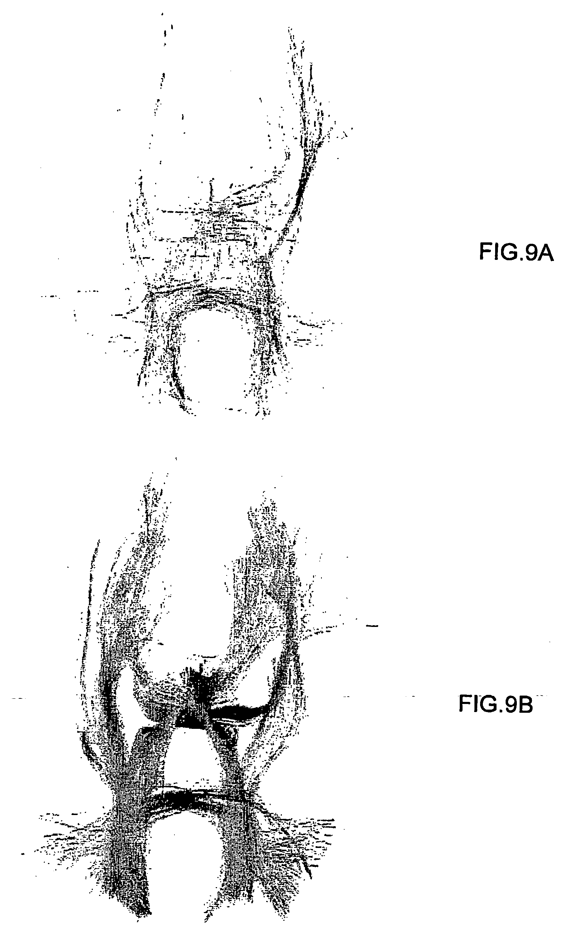

Les figures 9A et 9B montrent les résultats du suivi de fibres dans la matière blanche du cerveau humain respectivement sans prétraitement et après prétraitement (c'est-à-dire après filtrage et rééchantillonnage isotrope avec la métrique Log-Euclidienne).

Le suivi de fibres dans la matière blanche du cerveau à partir d'images de tenseurs de diffusion est une technique prometteuse pour la cartographie des connections neuronales dans tout système nerveux animal. On utilise ici un algorithme de suivi de fibres sur une image bruitée de tenseurs de diffusion de taille : 128 * 128 * 30 avec comme dimensions spatiales de voxel (3D) : 1,875 mm * 1,875 mm * 4 mm. Le processus de diffusion a été échantillonné selon 6 directions, avec un b-facteur de 1000. Par ailleurs, 100 itérations du filtrage décrit précédemment ont été réalisées, avec dt = 0,1 et κ = 0,05.

Comme on peut le constater, les fibres reconstituées sont bien plus régulières et nombreuses après prétraitement (figure 9B).

Dans ce qui précède on a décrit un second dispositif de traitement D' destiné à faire revenir au format initial d'une image de tenseurs des données représentatives de la troisième représentation R3, délivrée par le deuxième module de traitement MT2. Mais, l'invention propose également au moins deux variantes (D" et D"') du second dispositif de traitement D'.

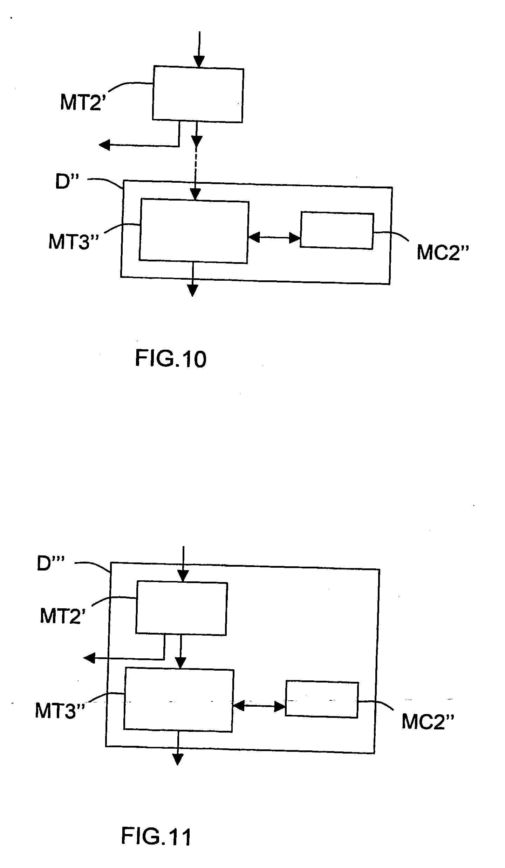

Une première variante D" est illustrée sur la figure 10, à titre d'exemple illustratif et non limitatif.

Dans cette première variante, le second dispositif de traitement D" reçoit d'un deuxième module de traitement MT2' des données représentatives d'une première représentation traitée R1' d'une image brute initiale.

Le deuxième module de traitement MT2' est ici destiné à effectuer un ou plusieurs traitements sur des données brutes initiales, représentatives d'une image brute de vecteurs initiale ou de matrices symétriques (mais non nécessairement définies positives) initiales, qui ne proviennent pas d'un premier dispositif de traitement D selon l'invention.

Les données à traiter proviennent ici directement d'un imageur (ou dispositif d'acquisition d'images). Il ne s'agit donc pas de données constituant une deuxième représentation R2 résultant du traitement effectué par le premier module de traitement MT1 sur une première représentation R1 d'une image de tenseurs initiale.

Par exemple, le deuxième module de traitement MT2' reçoit des données représentatives d'images de diffusion brutes issues d'imageurs.

Le deuxième module de traitement MT2' peut éventuellement (et comme illustré) comporter une sortie additionnelle permettant de délivrer des données complémentaires, par exemple sous la forme d'images de segmentation, utiles par ailleurs.

Il est important de noter qu'hormis l'origine des données à traiter le deuxième module de traitement MT2' est identique au deuxième module de traitement MT2 décrit précédemment en référence aux figures 1 et 2. Par conséquent, les traitements qu'il peut mettre en oeuvre sont identiques à ceux pouvant être mis en oeuvre par le deuxième module de traitement MT2.

Par exemple, le deuxième module de traitement MT2' peut traiter des images de type DT-MRI brutes afin de délivrer des (troisièmes) représentations destinées à faciliter l'estimation et la régularisation couplée d'images de tenseurs (délivrées par le second dispositif de traitement D").

L'intensité en chaque point x d'une série d'images de type DT-MRI brutes $I_i$ (par exemple i =1 à 6), acquises dans des directions spatiales $u_i$, peut se modéliser à partir d'une image de base $I_0$ selon la relation : $I_i(W(x)) = I_o(x)$. exp $(-b\ u_i^T$. exp$(W(x)).u_i)$.

Dans cette relation, W(x) est une image de matrices symétriques qui paramétrise (c'est-à-dire représente implicitement) une image de tenseurs qui est recherchée, notée $\Sigma(x) = \exp(W(x))$.

En pratique, on ne mesure pas l'intensité idéale $I_i(x)$ mais une version bruitée $\hat{I}_i(x)$, et on cherche à minimiser un critère de reconstruction qui est donné par la relation :

$$C(W) = Sim(W) + \lambda\ Reg(W),$$

constituée d'un terme d'attache aux données ($\Omega$ étant le domaine de l'image):

$$Sim(W) = \sum_i \int_\Omega dist^2 (I_i(W(x)), \hat{I}_i(x)) dx$$

et d'un terme de régularité Reg(W) donné par une $\Phi$-fonction :

$$\operatorname{Re}g(W) = \int_\Omega \Phi(\|\nabla W(x)\|^2) dx \ .$$

Ce critère peut ensuite être optimisé par de nombreuses techniques d'optimisation vectorielle faisant intervenir la dérivée ou non, comme par exemple les techniques dites Gauss-Newton ou Levenberg-Marquardt, ou la méthode de Powell.

Lorsque la méthode d'optimisation requiert la dérivée du critère, il est facile pour l'homme de l'art de calculer celle-ci à partir de la dérivée directionnelle de l'exponentielle de matrice. Par contre, cette dernière est *a priori* calculée au moyen d'un développement en série convergeant lentement. Il est cependant possible de calculer cette dernière plus efficacement avec un algorithme explicite ne faisant intervenir qu'une diagonalisation, comme pour le traitement effectué par le premier module de traitement MT1 : si $W = R.S.R^T$, alors $\partial_v \exp(W) = R. (\partial_R^T._{V·R} \exp(S)) .R^T$. Dans cette dernière formule, les composantes de la dérivée directionnelle selon Z de l'exponentielle d'une matrice diagonale $S = Diag(s_1, ... s_n)$ sont données explicitement par la relation :

$$\left[\partial_z \exp(S)\right]_{ij} = \frac{\exp(s_i) - \exp(s_j)}{s_i - s_j} . Z_{ij} .$$

Cela permet de gagner du temps de calcul et de la précision numérique.

La distance entre intensités, utilisée dans le terme d'attache aux données Sim(W), est habituellement choisie de la forme $dist^2(I,J) = (\log(I)-\log(J))^2$ car l'optimisation du critère conduit en l'absence de régularisation (c'est-à-dire lorsque À = 0) à une solution explicite de l'image de tenseurs recherchée $\Sigma(x) = \exp(W(x))$. Avec les techniques antérieures, l'ajout d'un terme de régularité spatiale conduit à un problème d'optimisation difficile puisque les méthodes vectorielles ne garantissent pas que les valeurs propres du tenseur recherché $\Sigma(x)$ restent positives.

L'utilisation de la (seconde) fonction du (second) module de calcul MC2", par le troisième module de traitement MT3" du second dispositif de traitement D", pour paramétriser l'image de tenseurs recherchée $\Sigma(x)$, permet ici de formuler le problème d'optimisation directement dans un espace vectoriel et transforme ce problème difficile en un problème simple, puisque l'on peut utiliser tout type de méthode d'estimation vectorielle. De plus, grâce à l'invention on peut désormais utiliser une distance entre intensités du type $dist^2(I,J) = (I - J)^2$, laquelle est adaptée au bruit réel sur les images de type IRM (lequel est approximativement gaussien), ce qui n'était pas le cas auparavant.

Une fois que le deuxième module de traitement MT2' a effectué son traitement (ici l'estimation à partir des images de type DT-MRI brutes), on utilise le second dispositif de traitement D" pour transformer le résultat de ce traitement ((troisième) représentation traitée (image de vecteurs traitée ou matrices symétriques traitées)) en une image de tenseurs. Cette transformation est identique à celle présentée ci-avant.

Il est rappelé que cette transformation est effectuée par le (troisième) module de traitement MT3" (identique à MT3 ou MT3'), et qu'elle consiste, d'une première part, à constituer une autre représentation traitée de l'image initiale à partir de la représentation traitée, délivrée par le deuxième module de traitement MT2', d'une deuxième part, à appeler le (second) module de calcul MC2" (identique à MC2 ou MC2') pour appliquer la (seconde) fonction à une partie choisie de l'autre représentation, afin de transformer cette partie en une partie transformée, et d'une troisième part, à constituer à partir de la partie transformée une image de tenseurs traitée.

Afin de mieux comprendre l'invention, on peut utiliser l'analogie avec les transformées de Fourier d'une image scalaire. La représentation tensorielle (image de tenseurs) correspond en effet à la représentation spatiale de l'image scalaire, et la représentation vectorielle au moyen d'une (première) fonction, par exemple de type logarithme, correspond à la représentation fréquentielle de l'image scalaire. Selon cette analogie, le premier dispositif de traitement D traite la représentation spatiale d'une image scalaire initiale en la convertissant dans le domaine des fréquences au moyen de son premier module de traitement MT1 et de son (premier) module de calcul MC1, le deuxième module de traitement MT2 effectue alors un ou plusieurs traitements sur la représentation fréquentielle de l'image scalaire, et le troisième module de traitement MT3 (ou MT3') et le (second) module de calcul MC2 (ou MC2') rétro-convertissent la représentation fréquentielle traitée de l'image scalaire en une représentation spatiale traitée de l'image scalaire (l'image de tenseurs, toujours par analogie).

Lorsque l'image scalaire initiale est de type fréquentiel, on utilise directement le deuxième module de traitement MT2' pour lui appliquer un ou plusieurs traitements, et le second dispositif de traitement D" (c'est-à-dire le troisième module de traitement MT3" et le (second) module de calcul MC2") rétro-convertit la représentation fréquentielle de l'image scalaire traitée par le deuxième module de traitement MT2' en une représentation spatiale traitée de l'image scalaire (l'image de tenseurs), toujours par analogie. Cela est particulièrement utile dans le cas des tenseurs lorsque l'estimation d'une image de tenseurs (éventuellement de diffusion) doit se faire directement à partir de données brutes qui ne sont pas des images de tenseurs, mais des images de vecteurs (ou des matrices symétriques) et donc ne sont pas susceptibles de subir une conversion préalable (tenseur/vecteur ou tenseur/matrice symétrique) du type de celle effectuée par le premier module de traitement MT1.

Il est important de noter que l'on peut envisager une variante D''' du second dispositif de traitement D", présenté ci-avant, qui intègre le deuxième module de traitement MT2'. Une telle variante est illustrée schématiquement et fonctionnellement, à titre d'exemple non limitatif, sur la figure 11.

Les variantes de second dispositif de traitement D" et D''', et notamment leur (deuxième) module de calcul MC2" et leur (troisième) module de traitement MT3", et leur éventuel (deuxième) module de traitement MT2', peuvent être réalisés sous la forme de circuits électroniques, de modules logiciels (ou informatiques), ou d'une combinaison de circuits et de logiciels.

L'invention peut être également considérée sous la forme d'un procédé de traitement de données d'images (brutes ou de tenseurs) initiales.

Celui-ci peut être mis en oeuvre à l'aide des (premier D et second D', D" ou D''') dispositifs de traitement présentés ci-avant. Les fonctions et sous-fonctions principales et optionnelles assurées par les étapes de ce procédé étant sensiblement identiques à celles assurées par les différents moyens constituant les dispositifs D et D', D" ou D''',

seules seront résumées ci-après les étapes mettant en oeuvre les fonctions principales du procédé selon l'invention.

Ce procédé comporte (dans le cas d'une application aux images initiales de tenseurs) :

- une première étape dans laquelle on constitue une première représentation R1 d'une image de tenseurs reçue,
- une deuxième étape dans laquelle on applique à une partie choisie de la première représentation R1 une première fonction choisie, bijective, définie de l'espace R $^{*+}$ dans l'espace R, et associée à une définition de métrique choisie, cette première fonction admettant une seconde fonction réciproque, de manière à obtenir une partie transformée, et
- une troisième étape dans laquelle on constitue à partir de la partie transformée une seconde représentation R2 de l'image de tenseurs prête à être traitée par filtrage.

Ces trois premières étapes peuvent être suivies par une quatrième étape de traitements (éventuellement par filtrage) aboutissant à une troisième représentation R3 de l'image de tenseurs, puis par :

- une cinquième étape dans laquelle on constitue une quatrième représentation R4 de l'image de tenseurs à partir de la troisième représentation R3,
- une sixième étape dans laquelle on applique à une partie choisie de cette quatrième représentation R4 une seconde fonction choisie, bijective et associée à ladite définition de métrique choisie, cette seconde fonction étant la fonction réciproque de la première fonction, afin d'obtenir de cette partie une partie transformée, et
- une septième étape dans laquelle on constitue une image de tenseurs traitée à partir de la partie transformée.

L'invention ne se limite pas aux modes de réalisation de dispositifs de traitement et de procédé de traitement décrits ci-avant, seulement à titre d'exemple, mais elle englobe toutes les variantes que pourra envisager l'homme de l'art dans le cadre des revendications ci-après.

**Revendications**

1. Dispositif (D) de traitement de données constituant des images de tenseurs initiales, chaque tenseur étant une matrice réelle symétrique et définie positive représentant une partie élémentaire d'une image de tenseurs reçue, **caractérisé en ce qu'**il comprend :

   - un premier module de calcul (MC1), capable de mettre en oeuvre une première fonction choisie, bijective, définie de l'espace R$^{*+}$ dans l'espace R , et associée à une métrique de type log-euclidienne choisie, cette première fonction admettant une seconde fonction réciproque, et

   un premier module de traitement (MT1) couplé au module de calcul et agencé pour i) constituer une première représentation matricielle d'une image de tenseurs reçue, ii) appeler le premier module de calcul (MC1) pour appliquer la première fonction à une partie matricielle choisie de la première représentation matricielle, de manière à obtenir une partie matricielle transformée, et iii) constituer à partir de cette partie matricielle transformée une seconde représentation matricielle de l'image de tenseurs propre à un traitement d'image ultérieur, et **en ce que** ledit premier module de traitement (MT1) est agencé pour i) constituer chaque première représentation matricielle sous la forme d'un produit d'une première matrice orthogonale, d'une matrice diagonale, constituée de coefficients et constituant ladite partie matricielle choisie, et d'une seconde matrice orthogonale, transposée de la première, ii) appeler ledit premier module de calcul (MC1) pour qu'il applique à chacun desdits coefficients situés sur la diagonale de ladite matrice diagonale ladite première fonction choisie, de manière à obtenir une matrice diagonale transformée constituant ladite partie matricielle transformée, puis iii) effectuer un produit entre ladite première matrice orthogonale, ladite matrice diagonale transformée et ladite seconde matrice orthogonale, de manière à délivrer une matrice finale symétrique au moins représentative de ladite seconde représentation.

2. Dispositif selon la revendication 1, **caractérisé en ce que** ladite matrice finale symétrique constitue ladite seconde représentation.

3. Dispositif selon la revendication 1, **caractérisé en ce que** ledit premier module de traitement (MT1) est agencé pour transformer une matrice finale symétrique de dimension n*n en un vecteur de dimension n(n+1)/2 constituant ladite seconde représentation.

4. Dispositif selon l'une des revendications 1 à 3, **caractérisé en ce qu'**il comprend un deuxième module de traitement (MT2) agencé pour appliquer au moins un traitement choisi à ladite seconde représentation de l'image de tenseurs reçue, de manière à délivrer une troisième représentation traitée de l'image de tenseurs reçue.

5. Dispositif selon la combinaison des revendications 3 et 4, **caractérisé en ce que** ledit deuxième module de traitement (MT2) est agencé pour appliquer un traitement vectoriel choisi à ladite seconde représentation.

6. Dispositif selon l'une des revendications 4 et 5, **caractérisé en ce qu'**il comprend :

   - un second module de calcul (MC2), capable de mettre en oeuvre une seconde fonction choisie, bijective et associée à ladite définition de métrique choisie, cette seconde fonction étant la fonction réciproque de ladite première fonction, et
   - un troisième module de traitement (MT3) agencé pour i) constituer une quatrième représentation de l'image de tenseurs reçue à partir de ladite troisième représentation, ii) appeler ledit second module de calcul (MC2) pour appliquer ladite seconde fonction à une partie choisie de ladite quatrième représentation, de manière à obtenir une partie transformée, et iii) constituer une image de tenseurs traitée à partir de ladite partie transformée.

7. Dispositif selon la revendication 6, **caractérisé en ce qu'**en présence d'une troisième représentation sous forme vectorielle, ledit troisième module de traitement (MT3) est agencé pour i) transformer ladite troisième représentation en une matrice intermédiaire symétrique de dimension n*n, ii) décomposer ladite matrice intermédiaire symétrique en un produit d'une troisième matrice orthogonale, d'une matrice diagonale, constituée de coefficients et constituant ladite partie choisie, et d'une quatrième matrice orthogonale, transposée de la troisième, iii) appeler ledit second module de calcul (MC2) pour appliquer à chacun desdits coefficients situés sur la diagonale de ladite matrice diagonale ladite seconde fonction choisie, de manière à obtenir une matrice diagonale transformée constituant ladite partie transformée, et iv) effectuer un produit entre ladite première matrice orthogonale, ladite matrice diagonale transformée et ladite seconde matrice orthogonale, de manière à délivrer ladite image de tenseurs traitée.

8. Dispositif selon la revendication 6, **caractérisé en ce qu'**en présence d'une troisième représentation sous la forme d'une matrice intermédiaire symétrique de dimension n*n, ledit troisième module de traitement (MT3) est agencé pour i) décomposer ladite matrice intermédiaire symétrique en un produit d'une troisième matrice orthogonale, d'une matrice diagonale, constituée de coefficients et constituant ladite partie choisie, et d'une quatrième matrice orthogonale, transposée de la troisième, ii) appeler ledit second module de calcul (MC2) pour appliquer à chacun desdits coefficients situés sur la diagonale de ladite matrice diagonale ladite seconde fonction choisie, de manière à obtenir une matrice diagonale transformée constituant ladite partie transformée, puis iii) effectuer un produit entre ladite première matrice orthogonale, ladite matrice diagonale transformée et ladite seconde matrice orthogonale, de manière à délivrer ladite image de tenseurs traitée.

9. Dispositif selon l'une des revendications 1 à 8, **caractérisé en ce que** ledit premier module de calcul (MC1) est agencé pour appliquer une première fonction à base logarithmique.

10. Dispositif selon la revendication 9, **caractérisé en ce que** ladite première fonction à base logarithmique est la fonction logarithme népérien (log) qui est associée à la seconde fonction réciproque exponentielle de néper (exp).

11. Dispositif selon la revendication 9, **caractérisé en ce que** ladite première fonction à base logarithmique est la fonction logarithme de base a ($\log_a$), avec $a \neq e$, laquelle est associée à la seconde fonction réciproque exponentielle de base a ($a^x = e^{x \log a}$).

12. Dispositif (D', D") de traitement de données constituant une première représentation matricielle traitée d'une image initiale, **caractérisé en ce qu'**il comprend :

    - un module de calcul (MC2'), capable de mettre en oeuvre une fonction choisie, bijective et associée à une métrique de type log-euclidienne, et
    - un module de traitement (MT3',MT3") couplé au module de calcul et agencé pour i) constituer une deuxième représentation traitée de l'image initiale à partir de ladite première représentation traitée, ii) appeler ledit module de calcul (MC2',MC2") pour appliquer ladite fonction à une partie matricielle choisie de ladite deuxième représentation, de manière à transformer cette partie matricielle en une partie matricielle transformée, et iii) constituer à partir de ladite partie matricielle transformée une image de tenseurs traitée.

13. Dispositif selon la revendication 12, **caractérisé en ce qu'**en présence d'une première représentation traitée sous forme vectorielle, ledit module de traitement (MT3',MT3") est agencé pour i) transformer ladite première représentation traitée en une matrice intermédiaire symétrique de dimension n*n, ii) décomposer ladite matrice intermédiaire symétrique en un produit d'une première matrice orthogonale, d'une matrice diagonale, constituée de coefficients et constituant ladite partie matricielle choisie, et d'une seconde matrice orthogonale, transposée de la première, iii) appeler ledit module de calcul (MC2',MC2") pour appliquer à chacun desdits coefficients situés sur la diagonale de ladite matrice diagonale ladite fonction choisie, de manière à obtenir une matrice diagonale transformée constituant ladite partie transformée, puis iv) effectuer un produit entre ladite première matrice orthogonale, ladite matrice diagonale transformée et ladite seconde matrice orthogonale, de manière à délivrer ladite image de tenseurs traitée.

**14.** Dispositif selon la revendication 12, **caractérisé en ce qu'**en présence d'une première représentation traitée sous la forme d'une matrice intermédiaire symétrique de dimension n*n, ledit module de traitement (MT3',MT3") est agencé pour i) décomposer ladite matrice intermédiaire symétrique en un produit d'une première matrice orthogonale, d'une matrice diagonale, constituée de coefficients et constituant ladite partie matricielle choisie, et d'une seconde matrice orthogonale, transposée de la première, ii) appeler ledit module de calcul (MC2',MC2") pour appliquer à chacun desdits coefficients situés sur la diagonale de ladite matrice diagonale ladite fonction choisie, de manière à obtenir une matrice diagonale transformée constituant ladite partie transformée, et iii) effectuer un produit entre ladite première matrice orthogonale, ladite matrice diagonale transformée et ladite seconde matrice orthogonale, de manière à délivrer ladite image de tenseurs traitée.

**15.** Dispositif selon l'une des revendications 12 à 14, **caractérisé en ce que** ledit module de calcul (MC2',MC2") est agencé pour appliquer une fonction exponentielle de base a choisie.

**16.** Dispositif selon la revendication 15, **caractérisé en ce que** ladite fonction exponentielle est la fonction exponentielle de base a = e qui est la réciproque de la fonction logarithme népérien (log).

**17.** Dispositif selon la revendication 15, **caractérisé en ce que** ladite fonction exponentielle est la fonction exponentielle de base $a \neq e$ ($a^x = e^{x\log a}$) qui est la réciproque de la fonction logarithme de base a ($\log_a$).

**18.** Dispositif selon l'une des revendications 12 à 17, **caractérisé en ce que** ladite première représentation traitée résulte de l'application d'au moins un traitement choisi à une représentation intermédiaire résultant de l'application à une partie choisie d'une représentation antérieure d'une image de tenseurs initiale d'une autre fonction choisie, bijective, définie de l'espace R $^{*+}$ dans l'espace R, et associée à ladite définition de métrique choisie, cette autre fonction étant la réciproque de la fonction mise en oeuvre par ledit module de calcul (MC2',MC2").

**19.** Dispositif selon l'une des revendications 12 à 18, **caractérisé en ce qu'**il comprend un deuxième module de traitement (MT2') agencé pour appliquer au moins un traitement choisi aux données représentatives d'une image initiale brute, de manière à délivrer ladite première représentation traitée.

**20.** Dispositif selon la revendication 19, **caractérisé en ce que** ledit deuxième module de traitement (MT2') est agencé pour appliquer un traitement vectoriel choisi aux données représentatives de ladite image initiale brute.

**21.** Procédé de traitement de données constituant des images de tenseurs initiales, chaque tenseur étant une matrice réelle symétrique et définie positive représentant une partie élémentaire d'une image de tenseurs reçue, **caractérisé en ce qu'**il consiste :

- à constituer une première représentation matricielle d'une image de tenseurs reçue,
- à appliquer à une partie matricielle choisie de ladite première représentation une première fonction choisie, bijective, définie de l'espace R $^{*+}$ dans l'espace R, et associée à une métrique log-euclidienne, cette première fonction admettant une seconde fonction réciproque, de manière à obtenir une partie matricielle transformée, et

à constituer à partir de ladite partie matricielle transformée une seconde représentation de ladite image de tenseurs propre à être traitée, et **en ce que** l'on constitue chaque première représentation sous la forme d'un produit d'une première matrice orthogonale, d'une matrice diagonale, constituée de coefficients et constituant ladite partie matricielle choisie, et d'une seconde matrice orthogonale, transposée de la première, **en ce que** l'on applique à chacun desdits coefficients situés sur la diagonale de ladite matrice diagonale ladite première fonction choisie, de manière à obtenir une matrice diagonale transformée constituant ladite partie matricielle transformée, et **en ce que** l'on effectue un produit entre ladite première matrice orthogonale, ladite matrice diagonale transformée et ladite seconde matrice orthogonale, de manière à délivrer une matrice finale symétrique au moins représentative de ladite seconde représentation.

**22.** Procédé selon la revendication 21, **caractérisé en ce que** ladite matrice finale symétrique constitue ladite seconde représentation.

**23.** Procédé selon la revendication 21, **caractérisé en ce que** l'on transforme une matrice finale symétrique de dimension n*n en un vecteur de dimension n(n+1)/2 constituant ladite seconde représentation.

**24.** Procédé selon l'une des revendications 21 à 23, **caractérisé en ce que** l'on applique au moins un traitement choisi à ladite seconde représentation de l'image de tenseurs reçue, de manière à obtenir une troisième représentation traitée de l'image de tenseurs reçue.

**25.** Procédé selon la combinaison des revendications 23 et 24, **caractérisé en ce que** l'on applique au moins un traitement vectoriel choisi à ladite seconde représentation.

**26.** Procédé selon l'une des revendications 24 et 25, **caractérisé en ce que** l'on constitue une quatrième représentation de l'image de tenseurs reçue à partir de ladite troisième représentation, puis on applique à une partie choisie de ladite quatrième représentation une seconde fonction choisie, bijective et associée à ladite définition de métrique choisie, cette seconde fonction étant la fonction réciproque de ladite première fonction, de manière à obtenir une partie transformée, et on constitue une image de tenseurs traitée à partir de ladite partie transformée.

**27.** Procédé selon la revendication 26, **caractérisé en ce qu'**en présence d'une troisième représentation sous forme vectorielle, i) on transforme ladite troisième représentation en une matrice intermédiaire symétrique de dimension n*n, puis ii) on décompose ladite matrice intermédiaire symétrique en un produit d'une troisième matrice orthogonale, d'une matrice diagonale, constituée de coefficients et constituant ladite partie choisie, et d'une quatrième matrice orthogonale, transposée de la troisième, puis iii) on applique à chacun desdits coefficients situés sur la diagonale de ladite matrice diagonale ladite seconde fonction choisie, de manière à obtenir une matrice diagonale transformée constituant ladite partie transformée, et iv) on effectue un produit entre ladite première matrice orthogonale, ladite matrice diagonale transformée et ladite seconde matrice orthogonale, de manière à délivrer ladite image de tenseurs traitée.

**28.** Procédé selon la revendication 26, **caractérisé en ce qu'**en présence d'une troisième représentation sous la forme d'une matrice intermédiaire symétrique de dimension n*n, i) on décompose ladite matrice intermédiaire symétrique en un produit d'une troisième matrice orthogonale, d'une matrice diagonale, constituée de coefficients et constituant ladite partie choisie, et d'une quatrième matrice orthogonale, transposée de la troisième, ii) on applique à chacun desdits coefficients situés sur la diagonale de ladite matrice diagonale ladite seconde fonction choisie, de manière à obtenir une matrice diagonale transformée constituant ladite partie transformée, et iii) on effectue un produit entre ladite première matrice orthogonale, ladite matrice diagonale transformée et ladite seconde matrice orthogonale, de manière à délivrer ladite image de tenseurs traitée.

**29.** Procédé selon l'une des revendications 21 à 28, **caractérisé en ce que** l'on applique une première fonction à base logarithmique.

**30.** Procédé selon la revendication 29, **caractérisé en ce que** ladite première fonction à base logarithmique est la fonction logarithme népérien (log) qui est associée à la seconde fonction réciproque exponentielle de néper (exp).

**31.** Procédé selon la revendication 29, **caractérisé en ce que** ladite première fonction à base logarithmique est la fonction logarithme de base a ($\log_a$), avec $a \neq e$, laquelle est associée à la seconde fonction réciproque exponentielle de base a ($a^x = e^{x\log a}$).

**Claims**

**1.** Device (D) for processing data forming initial tensor images, each tensor being a real symmetrical and positive definite matrix representing an elementary part of a received tensor image, **characterised in that** it comprises:

- a first calculation module (MC1) capable of carrying out a first selected function,

which is bijective, defined by the space $R^{*+}$ in the space R and associated with a selected log-Euclidean type metric, this first function having a second, reciprocal function, and a first processing module (MT1) coupled to the calculation module and arranged i) to form a first matrix representation of a received tensor image, ii) to call the first calculation module (MC1) to apply the first function to a selected matrix part of the first matrix representation so as to obtain a transformed matrix part and iii) to form, starting from that transformed matrix part, a second matrix representation of the tensor image which is suitable for subsequent image processing, and **in that** said first processing module (MT1) is arranged i) to form each first matrix representation in the form of a product of a first orthogonal matrix, of a diagonal matrix, composed of coefficients and forming said selected matrix part, and of a second orthogonal matrix, transposed from the first, ii) to call said first calculation module (MC1) so that it applies to each of said coefficients located on the diagonal of said diagonal matrix said first selected function so as to obtain a transformed diagonal matrix forming said transformed matrix part, and then iii) to establish a product of said first orthogonal matrix, said transformed diagonal matrix and said second orthogonal matrix so as to deliver a final symmetrical matrix at least representative of said second representation.

2. Device according to claim 1, **characterised in that** said final symmetrical matrix forms said second representation.

3. Device according to claim 1, **characterised in that** said first processing module (MT1) is arranged to transform a final symmetrical matrix of dimension n*n into a vector of dimension n(n+1)/2 forming said second representation.

4. Device according to one of claims 1 to 3, **characterised in that** it comprises a second processing module (MT2) arranged to apply at least one selected process to said second representation of the received tensor image so as to deliver a third processed representation of the received tensor image.

5. Device according to the combination of claims 3 and 4, **characterised in that** said second processing module (MT2) is arranged to apply a selected vectorial process to said second representation.

6. Device according to one of claims 4 and 5, **characterised in that** it comprises:

   - a second calculation module (MC2) capable of carrying out a second selected function, which is bijective and associated with said selected metric definition, this second function being the reciprocal function of said first function, and
   - a third processing module (MT3) arranged i) to form a fourth representation of the received tensor image starting from said third representation, ii) to call said second calculation module (MC2) to apply said second function to a selected part of said fourth representation so as to obtain a transformed part and iii) to form a processed tensor image starting from said transformed part.

7. Device according to claim 6, **characterised in that**, in the presence of a third representation in vectorial form, said third processing module (MT3) is arranged i) to transform said third representation into an intermediate symmetrical matrix of dimension n*n, ii) to decompose said intermediate symmetrical matrix into a product of a third orthogonal matrix, of a diagonal matrix, composed of coefficients and forming said selected part, and of a fourth orthogonal matrix, transposed from the third, iii) to call said second calculation module (MC2) to apply to each of said coefficients located on the diagonal of said diagonal matrix said second selected function so as to obtain a transformed diagonal matrix forming said transformed part, and iv) to establish a product of said first orthogonal matrix, said transformed diagonal matrix and said second orthogonal matrix so as to deliver said processed tensor image.

8. Device according to claim 6, **characterised in that**, in the presence of a third representation in the form of an intermediate symmetrical matrix of dimension n*n, said third processing module (MT3) is arranged i) to decompose said intermediate symmetrical matrix into a product of a third orthogonal matrix, of a diagonal matrix, composed of coefficients and forming said selected part, and of a fourth orthogonal matrix, transposed from the third, ii) to call said second calculation module (MC2) to apply to each of said coefficients located on the diagonal of said diagonal matrix said second selected function so as to obtain a transformed diagonal matrix forming said transformed part, and then iii) to establish a product of said first orthogonal matrix, said transformed diagonal matrix and said second orthogonal matrix so as to deliver said processed tensor image.

9. Device according to one of claims 1 to 8, **characterised in that** said first calculation module (MC1) is arranged to apply a first function which is logarithm-based.

10. Device according to claim 9, **characterised in that** said first function which is logarithm-based is the Napierian logarithm function (log) which is associated with the second reciprocal exponential function of Napier (exp).

**11.** Device according to claim 9, **characterised in that** said first function which is logarithm-based is the logarithm function of base a ($\log_a$) where $a \neq e$, which is associated with the second reciprocal exponential function of base a ($a^x = e^{x\log a}$).

**12.** Device (D', D'') for processing data forming a first processed matrix representation of an initial image, **characterised in that** it comprises:

- a calculation module (MC2') capable of carrying out a selected function, which is bijective and associated with a log-Euclidean type metric, and
- a processing module (MT3', MT3'') coupled to the calculation module and arranged i) to form a second processed representation of the initial image starting from said first processed representation, ii) to call said calculation module (MC2', MC2'') to apply said function to a selected matrix part of said second representation so as to transform that matrix part into a transformed matrix part and iii) to form, starting from said transformed matrix part, a processed tensor image.

**13.** Device according to claim 12, **characterised in that**, in the presence of a first processed representation in vectorial form, said processing module (MT3', MT3'') is arranged i) to transform said first processed representation into an intermediate symmetrical matrix of dimension n*n, ii) to decompose said intermediate symmetrical matrix into a product of a first orthogonal matrix, of a diagonal matrix, composed of coefficients and forming said selected matrix part, and of a second orthogonal matrix, transposed from the first, iii) to call said calculation module (MC2', MC2'') to apply to each of said coefficients located on the diagonal of said diagonal matrix said selected function so as to obtain a transformed diagonal matrix forming said transformed part, and then iv) to establish a product of said first orthogonal matrix, said transformed diagonal matrix and said second orthogonal matrix so as to deliver said processed tensor image.

**14.** Device according to claim 12, **characterised in that**, in the presence of a first processed representation in the form of an intermediate symmetrical matrix of dimension n*n, said processing module (MT3', MT3'') is arranged i) to decompose said intermediate symmetrical matrix into a product of a first orthogonal matrix, of a diagonal matrix, composed of coefficients and forming said selected matrix part, and of a second orthogonal matrix, transposed from the first, ii) to call said calculation module (MC2', MC2'') to apply to each of said coefficients located on the diagonal of said diagonal matrix said selected function so as to obtain a transformed diagonal matrix forming said transformed part, and iii) to establish a product of said first orthogonal matrix, said transformed diagonal matrix and said second orthogonal matrix so as to deliver said processed tensor image.

**15.** Device according to one of claims 12 to 14, **characterised in that** said calculation module (MC2', MC2'') is arranged to apply a selected exponential function of base a.

**16.** Device according to claim 15, **characterised in that** said exponential function is the exponential function of base a = e which is the reciprocal of the Napierian logarithm function (log).

**17.** Device according to claim 15, **characterised in that** said exponential function is the exponential function of base $a \neq e$ ($a^x = e^{x\log a}$) which is the reciprocal of the logarithm function of base a ($\log_a$).

**18.** Device according to one of claims 12 to 17, **characterised in that** said first processed representation results from the application of at least one selected process to an intermediate representation resulting from applying to a selected part of a prior representation of an initial tensor image another selected function, which is bijective, defined by the space R*+ in the space R and associated with said selected metric definition, this other function being the reciprocal of the function carried out by said calculation module (MC2', MC2'').

**19.** Device according to one of claims 12 to 18, **characterised in that** it comprises a second processing module (MT2') arranged to apply at least one selected process to the data representative of an unprocessed initial image so as to deliver said first processed representation.

**20.** Device according to claim 19, **characterised in that** said second processing module (MT2') is arranged to apply a selected vectorial process to the data representative of said unprocessed initial image.

**21.** Method of processing data forming initial tensor images, each tensor being a real symmetrical and positive definite matrix representing an elementary part of a received tensor image, **characterised in that** it comprises:

- forming a first matrix representation of a received tensor image,
- applying to a selected matrix part of said first representation a first selected function, which is bijective, defined by the space $R^{*+}$ in the space R and associated with a log-Euclidean metric, this first function having a second, reciprocal function, so as to obtain a transformed matrix part, and forming, from that transformed matrix part, a second representation of said tensor image which is suitable for being processed, and **in that** each first representation is formed in the form of a product of a first orthogonal matrix, of a diagonal matrix, composed of coefficients and forming said selected matrix part, and of a second orthogonal matrix, transposed from the first, **in that** there is applied to each of said coefficients located on the diagonal of said diagonal matrix said first selected function so as to obtain a transformed diagonal matrix forming said transformed matrix part, and **in that** there is established a product of said first orthogonal matrix, said transformed diagonal matrix and said second orthogonal matrix so as to deliver a final symmetrical matrix at least representative of said second representation.

22. Method according to claim 21, **characterised in that** said final symmetrical matrix forms said second representation.

23. Method according to claim 21, **characterised in that** a final symmetrical matrix of dimension n*n is transformed into a vector of dimension n(n+1)/2 forming said second representation.

24. Method according to one of claims 21 to 23, **characterised in that** at least one selected process is applied to said second representation of the received tensor image so as to obtain a third processed representation of the received tensor image.

25. Method according to the combination of claims 23 and 24, **characterised in that** at least one selected vectorial process is applied to said second representation.

26. Method according to one of claims 24 and 25, **characterised in that** a fourth representation of the received tensor image is formed starting from said third representation, there is then applied to a selected part of said fourth representation a second selected function, which is bijective and associated with said selected metric definition, this second function being the reciprocal function of said first function, so as to obtain a transformed part, and a processed tensor image is formed starting from said transformed part.

27. Method according to claim 26, **characterised in that**, in the presence of a third representation in vectorial form, i) said third representation is transformed into an intermediate symmetrical matrix of dimension n*n, then ii) said intermediate symmetrical matrix is decomposed into a product of a third orthogonal matrix, of a diagonal matrix, composed of coefficients and forming said selected part, and of a fourth orthogonal matrix, transposed from the third, then iii) to each of said coefficients located on the diagonal of said diagonal matrix there is applied said second selected function so as to obtain a transformed diagonal matrix forming said transformed part, and iv) a product is established between said first orthogonal matrix, said transformed diagonal matrix and said second orthogonal matrix so as to deliver said processed tensor image.

28. Method according to claim 26, **characterised in that**, in the presence of a third representation in the form of an intermediate symmetrical matrix of dimension n*n, i) said intermediate symmetrical matrix is decomposed into a product of a third orthogonal matrix, of a diagonal matrix, composed of coefficients and forming said selected part, and of a fourth orthogonal matrix, transposed from the third, ii) there is applied to each of said coefficients located on the diagonal of said diagonal matrix said second selected function so as to obtain a transformed diagonal matrix forming said transformed part, and iii) there is established a product of said first orthogonal matrix, said transformed diagonal matrix and said second orthogonal matrix so as to deliver said processed tensor image.

29. Method according to one of claims 21 to 28, **characterised in that** a first function which is logarithm-based is applied.

30. Method according to claim 29, **characterised in that** said first function which is logarithm-based is the Napierian logarithm function (log) which is associated with the second reciprocal exponential function of Napier (exp).

31. Method according to claim 29, **characterised in that** said first function which is logarithm-based is the logarithm function of base a ($\log_a$) where $a \neq e$, which is associated with the second reciprocal exponential function of base a ($a^x = e^{x \log a}$).

**EP 1 866 866 B1**

**Patentansprüche**

1. Vorrichtung (D) zur Verarbeitung von Daten, die Ausgangstensorbilder darstellen, wobei jeder Tensor eine reelle symmetrische und positiv definierte Matrix ist, die einen elementaren Teil eines empfangenen Tensorbildes darstellt, **dadurch gekennzeichnet, dass** sie umfasst:

   - ein erstes Berechnungsmodul (MC 1), das geeignet ist, eine ausgewählte erste bijektive Funktion, die von Raum R*⁺ in den Raum R definiert ist und die einer ausgewählten Metrik vom Typ Log-euklidisch zugeordnet ist, auszuführen, wobei diese erste Funktion eine reziproke zweite Funktion zulässt, und
   - ein erstes Verarbeitungsmodul (MT1), das mit dem Berechnungsmodul gekoppelt und angeordnet ist, um i) eine erste Matrixabbildung eines empfangenen Tensorbildes zu bilden, ii) das erste Berechnungsmodul (MC1) aufzurufen, um die erste Funktion auf einen ausgewählten Matrixteil der ersten Matrixabbildung anzuwenden, um einen transformierten Matrixteil zu erhalten, und iii) anhand dieses transformierten Matrixteils eine für eine spätere Bildverarbeitung geeignete zweite Matrixabbildung des Tensorbildes zu bilden, und dass das erste Verarbeitungsmodul (MT1) angeordnet ist, um i) jede erste Matrixabbildung in Form eines Produktes aus einer ersten Orthogonalmatrix , aus einer Diagonalmatrix, welche aus Koeffizienten besteht und den ausgewählten Matrixteil bildet, sowie aus einer zweiten Orthogonalmatrix, welche die Transponierte der ersten ist, zu bilden, ii) das erste Berechnungsmodul (MC1) aufzurufen, damit es auf einen jeden der auf der Diagonalen der Diagonalmatrix liegenden Koeffizienten die ausgewählte erste Funktion anwendet, um eine den transformierten Matrixteil bildende transformierte Diagonalmatrix zu erhalten, anschließend iii) ein Produkt aus der ersten Orthogonalmatrix, der transformierten Diagonalmatrix und der zweiten Orthogonalmatrix zu berechnen, um eine wenigstens für die zweite Abbildung repräsentative endgültige symmetrische Matrix zu liefern.

2. Vorrichtung nach Anspruch 1, **dadurch gekennzeichnet, dass** die endgültige symmetrische Matrix die zweite Abbildung darstellt.

3. Vorrichtung nach Anspruch 1, **dadurch gekennzeichnet, dass** das erste Verarbeitungsmodul (MT1) angeordnet ist, um eine endgültige symmetrische Matrix der Dimension n*n in einen die zweite Abbildung darstellenden Vektor der Dimension n(n+1)/2 zu transformieren.

4. Vorrichtung nach einem der Ansprüche 1 bis 3, **dadurch gekennzeichnet, dass** sie ein zweites Verarbeitungsmodul (MT2) umfasst, das angeordnet ist, um wenigstens eine ausgewählte Verarbeitung auf die zweite Abbildung des empfangenen Tensorbildes anzuwenden, um eine verarbeitete dritte Abbildung des empfangenen Tensorbildes zu liefern.

5. Vorrichtung nach der Kombination aus den Ansprüchen 3 und 4, **dadurch gekennzeichnet, dass** das zweite Verarbeitungsmodul (MT2) angeordnet ist, um eine ausgewählte Vektorverarbeitung auf die zweite Abbildung anzuwenden.

6. Vorrichtung nach einem der Ansprüche 4 und 5, **dadurch gekennzeichnet, dass** sie umfasst:

   - ein zweites Berechnungsmodul (MC2), das geeignet ist, eine ausgewählte zweite bijektive Funktion, die der ausgewählten Metrikdefinition zugeordnet ist, auszuführen, wobei diese zweite Funktion die reziproke Funktion der ersten Funktion ist, und
   - ein drittes Verarbeitungsmodul (MT3), das angeordnet ist, um i) eine vierte Abbildung des empfangenen Tensorbildes anhand der dritten Abbildung zu bilden, ii) das zweite Berechnungsmodul (MC2) aufzurufen, um die zweite Funktion auf einen ausgewählten Teil der vierten Abbildung anzuwenden, um einen transformierten Teil zu erhalten, und iii) ein verarbeitetes Tensorbild anhand des transformierten Teils zu bilden.

7. Vorrichtung nach Anspruch 6, **dadurch gekennzeichnet, dass** bei Vorliegen einer dritten Abbildung in vektorieller Form das dritte Verarbeitungsmodul (MT3) angeordnet ist, um i) die dritte Abbildung in eine symmetrische Zwischenmatrix der Dimension n*n zu transformieren, ii) die symmetrische Zwischenmatrix in ein Produkt aus einer dritten Orthogonalmatrix, aus einer Diagonalmatrix, welche aus Koeffizienten besteht und den ausgewählten Teil bildet, sowie aus einer vierten Orthogonalmatrix, welche die Transponierte der dritten ist, zu zerlegen, iii) das zweite Berechnungsmodul (MC2) aufzurufen, um auf einen jeden der auf der Diagonalen der Diagonalmatrix liegenden Koeffizienten die ausgewählte zweite Funktion anzuwenden, um eine den transformierten Teil darstellende transformierte Diagonalmatrix zu erhalten, und iv) ein Produkt aus der ersten Orthogonalmatrix, der transformierten Diagonalmatrix und der zweiten Orthogonalmatrix zu berechnen, um das verarbeitete Tensorbild zu liefern.

8. Vorrichtung nach Anspruch 6, **dadurch gekennzeichnet, dass** bei Vorliegen einer dritten Abbildung in Form einer symmetrischen Zwischenmatrix der Dimension n*n das dritte Verarbeitungsmodul (MT3) angeordnet ist, um i) die symmetrische Zwischenmatrix in ein Produkt aus einer dritten Orthogonalmatrix, aus einer Diagonalmatrix, welche aus Koeffizienten besteht und den ausgewählten Teil bildet, sowie aus einer vierten Orthogonalmatrix, welche die Transponierte der dritten ist, zu zerlegen, ii) das zweite Berechnungsmodul (MC2) aufzurufen, um auf einen jeden der auf der Diagonalen der Diagonalmatrix liegenden Koeffizienten die ausgewählte zweite Funktion anzuwenden, um eine den transformierten Teil bildende transformierte Diagonalmatrix zu erhalten, anschließend iii) ein Produkt aus der ersten Orthogonalmatrix, der transformierten Diagonalmatrix und der zweiten Orthogonalmatrix zu berechnen, um das verarbeitete Tensorbild zu liefern.

9. Vorrichtung nach einem der Ansprüche 1 bis 8, **dadurch gekennzeichnet, dass** das erste Berechnungsmodul (MC1) angeordnet ist, um eine erste logarithmisch basierte Funktion anzuwenden.

10. Vorrichtung nach Anspruch 9, **dadurch gekennzeichnet, dass** die erste logarithmisch basierte Funktion die Funktion Logarithmus naturalis (log) ist, die der zweiten reziproken Neperschen Exponentialfunktion (exp) zugeordnet ist.

11. Vorrichtung nach Anspruch 9, **dadurch gekennzeichnet, dass** die erste logarithmisch basierte Funktion die Logarithmusfunktion mit der Basis a ($\log_a$) ist, wobei $a \neq e$, welche der zweiten reziproken Exponentialfunktion mit der Basis a ($a^x = e^{x \log a}$) zugeordnet ist.

12. Vorrichtung (D', D") zur Verarbeitung von Daten, die eine verarbeitete erste Matrixabbildung eines Ausgangsbildes darstellen, **dadurch gekennzeichnet, dass** sie umfasst:

    - ein Berechnungsmodul (MC2'), das geeignet ist, eine ausgewählte bijektive Funktion, die einer Metrik vom Typ Log-euklidisch zugeordnet ist, auszuführen, und
    - ein Verarbeitungsmodul (MT3', MT3"), das mit dem Berechnungsmodul gekoppelt und angeordnet ist, um i) eine verarbeitete zweite Abbildung des Ausgangsbildes anhand der verarbeiteten ersten Abbildung zu bilden, ii) das Berechnungsmodul (MC2', MC2") aufzurufen, um die Funktion auf einen ausgewählten Matrixteil der zweiten Abbildung anzuwenden, um diesen Matrixteil in einen transformierten Matrixteil zu transformieren, und iii) anhand des transformierten Matrixteils ein verarbeitetes Tensorbild zu bilden.

13. Vorrichtung nach Anspruch 12, **dadurch gekennzeichnet, dass** bei Vorliegen einer verarbeiteten ersten Abbildung in vektorieller Form das Verarbeitungsmodul (MT3', MT3") angeordnet ist, um i) die verarbeitete erste Abbildung in eine symmetrische Zwischenmatrix der Dimension n*n zu transformieren, ii) die symmetrische Zwischenmatrix in ein Produkt aus einer ersten Orthogonalmatrix, aus einer Diagonalmatrix, welche aus Koeffizienten besteht und den ausgewählten Matrixteil bildet, sowie aus einer zweiten Orthogonalmatrix, welche die Transponierte der ersten ist, zu zerlegen, iii) das Berechnungsmodul (MC2', MC2") aufzurufen, um auf einen jeden der auf der Diagonalen der Diagonalmatrix liegenden Koeffizienten die ausgewählte Funktion anzuwenden, um eine den transformierten Teil bildende transformierte Diagonalmatrix zu erhalten, anschließend iv) ein Produkt aus der ersten Orthogonalmatrix, der transformierten Diagonalmatrix und der zweiten Orthogonalmatrix zu berechnen, um das verarbeitete Tensorbild zu liefern.

14. Vorrichtung nach Anspruch 12, **dadurch gekennzeichnet, dass** bei Vorliegen einer verarbeiteten ersten Abbildung in Form einer symmetrischen Zwischenmatrix der Dimension n*n das Verarbeitungsmodul (MT3', MT3") angeordnet ist, um i) die symmetrische Zwischenmatrix in ein Produkt aus einer ersten Orthogonalmatrix, aus einer Diagonalmatrix, welche aus Koeffizienten besteht und den ausgewählten Matrixteil bildet, sowie aus einer zweiten Orthogonalmatrix, welche die Transponierte der ersten ist, zu zerlegen, ii) das Berechnungsmodul (MC2', MC2") aufzurufen, um auf einen jeden der auf der Diagonalen der Diagonalmatrix liegenden Koeffizienten die ausgewählte Funktion anzuwenden, um eine den transformierten Teil bildende transformierte Diagonalmatrix zu erhalten, und um iii) ein Produkt aus der ersten Orthogonalmatrix, der transformierten Diagonalmatrix und der zweiten Orthogonalmatrix zu berechnen, um das verarbeitete Tensorbild zu liefern.

15. Vorrichtung nach einem der Ansprüche 12 bis 14, **dadurch gekennzeichnet, dass** das Berechnungsmodul (MC2', MC2") angeordnet ist, um eine ausgewählte Exponentialfunktion mit der Basis a anzuwenden.

16. Vorrichtung nach Anspruch 15, **dadurch gekennzeichnet, dass** die Exponentialfunktion die Exponentialfunktion mit der Basis a = e ist, welche die Reziproke der Funktion Logarithmus naturalis (log) ist.

**17.** Vorrichtung nach Anspruch 15, **dadurch gekennzeichnet, dass** die Exponentialfunktion die Exponentialfunktion mit der Basis $a \neq e$ ($a^x = e^{x \log a}$) ist, welche die Reziproke der Logarithmusfunktion mit der Basis a ($\log_a$) ist.

**18.** Vorrichtung nach einem der Ansprüche 12 bis 17, **dadurch gekennzeichnet, dass** die verarbeitete erste Abbildung aus der Anwendung wenigstens einer ausgewählten Verarbeitung auf eine Zwischenabbildung resultiert, welche aus der Anwendung einer weiteren ausgewählten bijektiven Funktion, die von Raum $R^{*+}$ in Raum R definiert ist und die der ausgewählten Metrikdefinition zugeordnet ist, auf einen ausgewählten Teil einer früheren Abbildung eines Ausgangstensorbildes hervorgeht, wobei diese weitere Funktion die Reziproke der durch das Berechnungsmodul (MC2', MC2") ausgeführten Funktion ist.

**19.** Vorrichtung nach einem der Ansprüche 12 bis 18, **dadurch gekennzeichnet, dass** sie ein zweites Verarbeitungsmodul (MT2") umfasst, das angeordnet ist, um wenigstens eine ausgewählte Verarbeitung auf die für ein Ausgangsrohbild repräsentativen Daten anzuwenden, um die verarbeitete erste Abbildung zu liefern.

**20.** Vorrichtung nach Anspruch 19, **dadurch gekennzeichnet, dass** das zweite Verarbeitungsmodul (MT2") angeordnet ist, um auf die für das Ausgangsrohbild repräsentativen Daten eine ausgewählte Vektorverarbeitung anzuwenden.

**21.** Verfahren zur Verarbeitung von Daten, die Ausgangstensorbilder darstellen, wobei jeder Tensor eine reelle symmetrische und positiv definierte Matrix ist, die einen elementaren Teil eines empfangenen Tensorbildes darstellt, **dadurch gekennzeichnet, dass** es darin besteht:

- eine erste Matrixabbildung eines empfangenen Tensorbildes zu bilden,
- auf einen ausgewählten Matrixteil der ersten Abbildung eine ausgewählte erste bijektive Funktion, die von Raum $R^{*+}$ in Raum R definiert ist und die einer Log-euklidischen Metrik zugeordnet ist, anzuwenden, wobei diese erste Funktion eine reziproke zweite Funktion zulässt, um einen transformierten Matrixteil zu erhalten, und anhand des transformierten Matrixteils eine für eine Verarbeitung geeignete zweite Abbildung des Tensorbildes zu bilden, und dass jede erste Abbildung in Form eines Produktes aus einer ersten Orthogonalmatrix , aus einer Diagonalmatrix, welche aus Koeffizienten besteht und den ausgewählten Matrixteil bildet, sowie aus einer zweiten Orthogonalmatrix, welche die Transponierte der ersten ist, gebildet wird, dass auf einen jeden der auf der Diagonalen der Diagonalmatrix liegenden Koeffizienten die ausgewählte erste Funktion angewandt wird, um eine den transformierten Matrixteil bildende transformierte Diagonalmatrix zu erhalten, und dass ein Produkt aus der ersten Orthogonalmatrix, der transformierten Diagonalmatrix und der zweiten Orthogonalmatrix berechnet wird, um eine wenigstens für die zweite Abbildung repräsentative endgültige symmetrische Matrix zu liefern.

**22.** Verfahren nach Anspruch 21, **dadurch gekennzeichnet, dass** die endgültige symmetrische Matrix die zweite Abbildung darstellt.

**23.** Verfahren nach Anspruch 21, **dadurch gekennzeichnet, dass** eine endgültige symmetrische Matrix der Dimension n*n in einen die zweite Abbildung darstellenden Vektor der Dimension n(n+1)/2 transformiert wird.

**24.** Verfahren nach einem der Ansprüche 21 bis 23, **dadurch gekennzeichnet, dass** wenigstens eine ausgewählte Verarbeitung auf die zweite Abbildung des empfangenen Tensorbildes angewandt wird, um eine verarbeitete dritte Abbildung des empfangenen Tensorbildes zu erhalten.

**25.** Verfahren nach der Kombination aus den Ansprüchen 23 und 24, **dadurch gekennzeichnet, dass** wenigstens eine ausgewählte Vektorverarbeitung auf die zweite Abbildung angewandt wird.

**26.** Verfahren nach einem der Ansprüche 24 und 25, **dadurch gekennzeichnet, dass** eine vierte Abbildung des empfangenen Tensorbildes anhand der dritten Abbildung gebildet wird, dann auf einen ausgewählten Teil der vierten Abbildung eine ausgewählte zweite bijektive Funktion, die der ausgewählten Metrikdefinition zugeordnet ist, angewandt wird, wobei diese zweite Funktion die reziproke Funktion der ersten Funktion ist, um einen transformierten Teil zu erhalten, und anhand des transformierten Teils ein verarbeitetes Tensorbild gebildet wird.

**27.** Verfahren nach Anspruch 26, **dadurch gekennzeichnet, dass** bei Vorliegen einer dritten Abbildung in vektorieller Form i) die dritte Abbildung in eine symmetrische Zwischenmatrix der Dimension n*n transformiert wird, anschließend ii) die symmetrische Zwischenmatrix in ein Produkt aus einer dritten Orthogonalmatrix, aus einer Diagonalmatrix, welche aus Koeffizienten besteht und den ausgewählten Teil bildet, sowie aus einer vierten Orthogonalmatrix, welche die Transponierte der dritten ist, zerlegt wird, dann iii) auf einen jeden der auf der Diagonalen der Diagonalmatrix liegenden Koeffizienten die ausgewählte zweite Funktion angewandt wird, um eine den transformierten Teil darstellende transformierte Diagonalmatrix zu erhalten, und iv) ein Produkt aus der ersten Orthogonalmatrix, der transformierten Diagonalmatrix und der zweiten Orthogonalmatrix berechnet wird, um das verarbeitete Tensorbild zu liefern.

28. Verfahren nach Anspruch 26, **dadurch gekennzeichnet, dass** bei Vorliegen einer dritten Abbildung in Form einer symmetrischen Zwischenmatrix der Dimension n*n i) die symmetrische Zwischenmatrix in ein Produkt aus einer dritten Orthogonalmatrix, aus einer Diagonalmatrix, welche aus Koeffizienten besteht und den ausgewählten Teil bildet, sowie aus einer vierten Orthogonalmatrix, welche die Transponierte der dritten ist, zerlegt wird, ii) auf einen jeden der auf der Diagonalen der Diagonalmatrix liegenden Koeffizienten die ausgewählte zweite Funktion angewandt wird, um eine den transformierten Teil bildende transformierte Diagonalmatrix zu erhalten, und iii) ein Produkt aus der ersten Orthogonalmatrix, der transformierten Diagonalmatrix und der zweiten Orthogonalmatrix berechnet wird, um das verarbeitete Tensorbild zu liefern.

29. Verfahren nach einem der Ansprüche 21 bis 28, **dadurch gekennzeichnet, dass** eine erste logarithmisch basierte Funktion angewandt wird.

30. Verfahren nach Anspruch 29, **dadurch gekennzeichnet, dass** die erste logarithmisch basierte Funktion die Funktion Logarithmus naturalis (log) ist, die der zweiten reziproken Neperschen Exponentialfunktion (exp) zugeordnet ist.

31. Verfahren nach Anspruch 29, **dadurch gekennzeichnet, dass** die erste logarithmisch basierte Funktion die Logarithmusfunktion mit der Basis a ($\log_a$) ist, wobei a ≠ e, welche der zweiten reziproken Exponentialfunktion mit der Basis a ($a^x = e^{x\log a}$) zugeordnet ist.

FIG.1

FIG.2

EP 1 866 866 B1

FIG.3

FIG.4

FIG.5

26

FIG.6

FIG.7

FIG.8

FIG.9A

FIG.9B

MT2'

D"

MT3"

MC2"

FIG.10

D'''

MT2'

MT3"

MC2"

FIG.11

## RÉFÉRENCES CITÉES DANS LA DESCRIPTION

**Littérature non-brevet citée dans la description**

- **X. PENNEC et al.** A Riemannian framework for tensor computing. *Research Report 5255, INRIA,* Juillet 2004
- Principal geodesic analysis on symmetric spaces : Statistics of diffusion tensors. **P.T. FLETCHER et al.** Proc. of CVAMIA and MMBIA Workshops. Springer, 15 Mai 2004, 87-98
- **C. LENGLET et al.** Statistics on multivariate normal statistics on multivariate normal distributions : A geometric approach and its application to diffusion tensor mri. *Technical report, INRIA,* Juin 2004
- **X. PENNEC.** Probabilities and Statistics on Riemannian Manifolds : A Geometric approach. *Research Report 5093, INRIA,* Janvier 2004
- **J. WEICKERT et al.** *Diffusion and Regularization of Vector- and Matrix-Valued Images,* 2002
- **GERIG et al.** Non-Linear Anisotropic Filtering of MRI Data. *IEEE Transactions in Medical Imaging,* Juin 1992, vol. 11 (2), 221-232